# EUROPEAN PATENT APPLICATION

(11) **EP 4 306 688 A1**
(43) Date of publication of application: **17.01.2024**
(21) Application number: 22184735.3
(22) Date of filing: 13.07.2022
(51) Int. Cl.: C30B 29/36, C30B 25/12, C01B 32/956, C23C 16/32, C23C 16/458

(54) **METHOD AND DEVICE FOR PRODUCING A SIC SOLID MATERIAL**

(71) Applicant: Zadient Technologies SAS, 73800 Sainte-Hélène-du-Lac (FR)
(72) Inventor: Ceran, Kagan, 73190 Saint Baldoph (FR); Schaaff, Fiedrich, 06116 Halle (DE); Tiefel, Hilmar Richard, 01219 Dresden (DE); Richter, Jan, 01277 Dresden (DE)
(74) Representative: Kehl, Ascherl, Liebhoff & Ettmayr Patentanwälte Partnerschaft mbB

(57) **Abstract**

The before mentioned object is solved by a SiC production reactor (850), wherein the SiC production reactor (850) at least comprises:
A process chamber (856), wherein the process chamber (856) is at least surrounded by a bottom wall section, in particular a base plate (862) or base plate wall section, a side wall section (864a) and a top wall section (864b),
a gas inlet unit (866) for feeding one feed-medium or multiple feed-mediums into a reaction space of the process chamber (856) for generating a source medium,
wherein the gas inlet unit (866) is coupled with at least one feed-medium source (851),
wherein a Si and C feed-medium source (851) is configured to provide at least Si and C, in particular SiCl3(CH3), and wherein a carrier gas feed-medium source (853) provides a carrier gas, in particular H2, or wherein the gas inlet unit (866) is coupled with at least two feed-medium sources (851, 852),
wherein a Si feed medium source (851) is configured to provide at least Si and wherein a C feed medium source (852) provides at least C, in particular natural gas, Methane, Ethane, Propane, Butane and/or Acetylene, and wherein a carrier gas medium source (853) is configured to provide a carrier gas, in particular H2,
at least one SiC growth substrate surface (2204) is formed inside the process chamber (856) by a wall surface section (2270),
a heating unit (2230) for non-electrically generation of heat is provided, wherein the heating unit (2230) is configured for heating at least the SiC growth substrate surface (2204) to a temperature above 1300°C.

## Description

Power electronics based on silicon carbide (SiC) wafers exhibit improved performance over those based on conventional silicon (Si) wafers, primarily due to the wider bandgap of SiC which allows it to operate at higher voltages, temperatures, and frequencies. With the worldwide transition to electric vehicles (EVs) gaining momentum, there is an increased interest in high performance SiC based power electronics, but SiC wafers remain considerably more expensive than Si wafers.

Currently, the prevailing method for commercial production of SiC single crystals is physical vapor transport (PVT).

Presently, industrial SiC source material used is produced via the commercial Acheson process and then further purified by powdering and acid leaching. The Acheson process is yet the only known process for the production of SiC source material in industrial scale. Acid leaching is used to extract trace metals from the SiC but only penetrates to a depth of approximately less than 1 micron from the surface of the particles. Thus, the particles need to be small enough so that this penetration layer constitutes a sufficient ratio of the total volume of the particle. Consequently, the power SiC particles typically need to have an average particle size of 200-300 microns. At this average particle size, this material can only be purified to approximately 99.99% or 99.999%, otherwise referred to as 4N or 5N purity respectively.

In some cases, silicon powder is used, in particular mixed with graphite powder and sintered, to produce SiC source material. Powdering SiC material creates high surface area for contamination during handling and exposure to air. The main contaminants of concern are trace metals, nitrogen, and oxygen.

Despite the only moderate 4N or 5N purity of these acid leached or sintered SiC materials they are expensive and contribute significantly to the overall high cost of resultant SiC wafers. The moderate purity also contributes to high wafer costs in that impurities cause defects in crystals that must then be discarded rather than sliced into wafers. In other words, impurities in the source material contribute to low crystal yield.

The presence of trace metals in SiC source material are considered to be a major root cause for crystal defects of the resulting single crystal SiC boule grown by PVT. Currently the quality of singly crystal SiC boule in terms of crystal defects like dislocations is orders of magnitude below that of other semiconducting crystals like silicon or GaAs. These crystal defects lead to unwanted electrical shortcuts in SiC electrical devices (which in most cases are vertical devices) and diminish the electrical device yield. It is therefore mandatory to find a better solution to prevent crystal defects resulting from source material impurities.

Furthermore, metal impurities in a SiC wafer manufactured from a single crystal SiC boule interact with the subsequent implant and doping technologies to manufacture a SiC electrical device, which could lead to device failure and diminishes electrical devices yield.

Furthermore, concentrations or bands of impurities, in particular nitrogen, develop in the boule which then results in wafers from different heights in the same boule with conductivity that may be outside of the required range or varies from one side of a wafer to another. In the case of semi-insulating SiC wafers for RF applications, very low conductivity is required and therefore very low concentrations of trace metals and nitrogen are permissible in the wafer. In the case of conductive SiC wafers for power applications, a certain amount of conductivity is required. But this conductivity is achieved uniformly throughout the SiC boule by providing nitrogen gas into the PVT crucible during the entire growth time.

Form factor of the SiC source material is also important in PVT growth. Powder source material provides high initial surface area for sublimation and therefore a high initial sublimation rate. A high sublimation rate can be uneconomic in the event that all the vaporized SiC species cannot be incorporated into the crystal and become parasitic polycrystalline depositions on other parts of the crucible. Worse, high concentrations of SiC species in front of the crystal growth face can lead to nucleation in the vapor phase and formation of amorphous or polycrystalline inclusions in the monocrystalline boule. Over time, the powder source material tends to sinter together creating a single block of material with substantially reduced surface area and therefore tailing sublimation rate. This spiking and tailing sublimation curve for power source material results in overall slow growth with the possibility of defects in the grown crystal. Finally, powder source material, has a low tap density of approximately 1.2 g/cm³ which limits the mass of material that can be loaded into the crucible and therefore the size of the crystal that can be grown.

Document GB1128757 discloses a method for the depositing of a thin coating of SiC. However, the teaching of GB1128757 does not relate to a method for the production of large quantities of SiC as PVT source material.

DE1184738 (B) discloses a method for producing silicon carbide crystals in monocrystalline and polycrystalline form by reacting silicon halides with carbon tetrachloride in a molar ratio of 1:1 in the presence of hydrogen on heated graphite bodies. In this process, a mixture of 1 volume percent silicon chloroform, 1 volume percent carbon tetrachloride and hydrogen is first passed over the graphite body at a flow rate of 400 to 600 l/h until a compact silicon carbide layer is formed on the graphite body, and then at a flow rate of 250 to 350 l/h over the deposition body at 1300°C to 2000°C, in particular at 1500°C to 1600°C.

This state of the art is disadvantageous because it does not meet today's requirements for high-purity SiC cheaply produced in large scale industrial processes. SiC is used in many areas of technology, in particular power applications and/or electromobility, to increase efficiency. In order for the products requiring SiC to be accessible to a mass market, the manufacturing costs must decrease and/or the quality must increase.

It is therefore the object of the present invention to provide a low-cost supply of silicon carbide (SiC). Additionally, or alternatively, high purity SiC shall be provided. Additionally, or alternatively SiC shall be provided very fast. Additionally, or alternatively SiC shall be producible very effectively. Additionally, or alternatively, monocrystalline SiC having advantageous properties shall be produced.

The above-mentioned object is solved by a SiC production reactor, in particular for the production of PVT source material, according to claim 1. Said SiC production reactor preferably comprises at least a process chamber, wherein the process chamber is at least surrounded by a bottom wall section, in particular base plate or base plate wall section, a side wall section and a top wall section, a gas inlet unit for feeding one feed-medium or multiple feed-mediums into a reaction space of the process chamber for generating a source medium, wherein the gas inlet unit is coupled with at least one feed-medium source. The at least one feed-medium source is preferably a Si and C feed-medium source, which is preferably configured to provide at least Si and C, in particular SiCl3(CH3), and wherein a carrier gas feed-medium source is preferably provided which is configured to provide a carrier gas, in particular H2. Alternatively the gas inlet unit is preferably coupled with at least two feed-medium sources, wherein the at least two feed-medium sources preferably comprise a Si feed medium source which is preferably configured to provide at least Si and wherein a C feed medium source is preferably configured to provide at least C, in particular natural gas, Methane, Ethane, Propane, Butane and/or Acetylene, and wherein preferably a carrier gas medium source is provided which preferably provides a carrier gas, in particular H2. The SiC production reactor also comprises multiple SiC growth substrates, in particular more than 3 or 4 or 6 or 8 or 16 or 32 or 64 or up to 128 or up to 256, are arranged inside the process chamber for depositing SiC, wherein a first SiC growth substrate of said multiple SiC growth substrates comprises at least a first growth face section facing into a first directing and a second growth face section facing into a second direction, wherein the second direction is aligned less than 20°, in particular less than 10° or less than 5°, to the opposite direction of the first direction, wherein a second SiC growth substrate of said multiple SiC growth substrates comprises at least a third growth face section facing into the third direction, wherein the third direction is aligned less than 20°, in particular less than 10° or less than 5°, to the first direction and a fourth growth face section facing into a fourth direction, wherein a third SiC growth substrate of said multiple SiC growth substrates comprises at least a fifth growth face section facing into the fifth direction, wherein the fifth direction is aligned less than 20°, in particular less than 10° or less than 5°, to the third direction and a sixth growth face section facing into a sixth direction. The fourth growth face section preferably overlays in the first direction at least 50% of the first growth face section, wherein the size of the fourth growth face section is at least 80%, in particular more than 90% or more 95%, of the size of the first growth face section and/or wherein the sixth growth face section preferably overlays in the fifth direction at least 50% of the third growth face section, wherein the size of the sixth growth face section is at least 80%, in particular more than 90% or more 95%, of the size of the third growth face section.

This solution is beneficial since large surfaces are already present at the beginning of a production run and therefore allows fast deposition of SiC. Furthermore, since the multiple growth faces have a significant overlap heat radiation radiated form one growth face heats the overlapping growth face. Thus, heat losses can be reduced and therefore the overall production process can be carried out with less energy.

The distance of the opposing surface is preferably a defined distance, wherein that distance allows both high energy savings that and high-volume production that favors a long growth rate that results in thick deposition and wider spacing. Thus, a preferred arrangement between the plates respectively the opposing or overlaying growth face section is in between 10cm and 50 cm, in particular between 10cm and 40cm and preferably between 10cm and 30cm or between 20cm and 50cm and preferably between 30cm and 50cm, and the deposition thickness of SIC is preferably up to 1/3 of the spacing on each side. This means that at the end of the run preferably up to 2/3 of the initial spacing is filled with SiC and preferably 1/3 is left open for gas supply. Other arrangement are possible as well to optimize the gas flow and the gas conversion rate during the process. Highly preferably the deposition of SiC is less than 1/3 on each side to cause beneficial gas flux and gas turbulence.

Further preferred embodiments are subject-matter of the following specification parts and/or of the dependent claims.

According to a preferred embodiment of the present invention at least the first SiC growth substrate covers from at least two sides a first heating unit, wherein the first heating unit and the first SiC growth substrate are configured to be non-destructively separatable from each other. This embodiment is beneficial since the heating unit does not have to be part of the SiC growth substrate, thus heating can be carried out different to heating resulting from conducting electric energy through the SiC growth substrate. Electric heating requires an adequate electric infrastructure which is very expensive and therefore increases the overall production costs. Thus, due to the present invention significant capex reduction can be caused.

According to a further preferred embodiment of the present invention the first SiC growth substrate is formed by a hollow housing, wherein the heating unit is positioned inside the hollow housing. This embodiment is beneficial since the heating unit radiates heat to multiple wall sections of the hollow housing and therefore heats the walls of the hollow housing and thereby heats the outer surface sections of the hollow housing and causes them to act as SiC growth faces.

According to a further preferred embodiment of the present invention the first SiC growth substrate is formed by a foil or holds a SiC growth foil. This embodiment is beneficial since the SiC deposits on the foil and therefore increases stability of the foil. Due to deposition of SiC on the foil the SiC can be removed from the process chamber by removing the foil from the process chamber.

According to a further preferred embodiment of the present invention the foil is arranged around at least two surface sections of a hollow housing respectively of the hollow housing, wherein the heating unit is positioned inside the hollow housing. This embodiment is beneficial since the hollow housing on the one hand protects the heating unit from SiC and on the other hand holds the foil to allow defined deposition of SiC onto the foil. The heating unit is preferably arranged inside the hollow housing in such a manner that a defined temperature distribution is set or can be set. Due to the defined temperature distribution the outer surface sections of the hollow housing are heated which are overlayed by the foil. The remaining surface section of the hollow housing are preferably less heated, in particular more than 5°C less or more than 10°C less or more than 20°C less or more than 50°C less. The walls of the hollow housing can be thinner in sections where the foil has to be located compared to sections where the foil does not contact the hollow housing. Thinner preferably means more than 1mm thinner and highly preferably more than 3mm thinner and most preferably more than 5mm or 9mm or 15mm thinner.

According to a further preferred embodiment of the present invention the foil and/or the hollow housing is/are made of CFC (carbon fiber composite) material, in particular the foil and/or the hollow housing comprises more than 75%-mass CFC material or more than 90%-mass CFC material or more than 95%-mass CFC material or more than 99%-mass CFC material or up to 100%-mass CFC material. The CFC material preferably forms sheets, wherein the hollow housing and/or the foil is/are preferably formed by multiple sheets or a sheet-like structure. Alternatively, the foil and/or hollow housing can be made of molybdenum or can comprise molybdenum.

Thus, the hollow housing and/or the foil and/or wall member respectively SiC growth substrate comprises according to a further preferred embodiment of the present invention carbon fibers. This embodiment is beneficial since carbon fibers can heated to temperatures above 1500°C or above 1800°C or between 1400°C and 2000°C. Furthermore, high tensile loads can be applied to carbon fibers. Carbon fibers have several advantages including high stiffness, high tensile strength, high strength to weight ratio, high chemical resistance, high temperature tolerance and low thermal expansion. The atomic structure of carbon fiber is similar to that of graphite, consisting of sheets of carbon atoms arranged in a regular hexagonal pattern (graphene sheets), the difference being in the way these sheets interlock. Graphite is a crystalline material in which the sheets are stacked parallel to one another in regular fashion. The intermolecular forces between the sheets are relatively weak Van der Waals forces, giving graphite its soft and brittle characteristics.

The hollow housing and/or the foil and/or wall member respectively SiC growth substrate is according to a further preferred embodiment of the present invention formed by a carbon fiber composite material. This embodiment is beneficial since the fiber orientation with carbon fiber composite materials covers at least two directions and therefore allows also compensation forces in multiple directions. An example of a preferred carbon fiber composite material is e.g., SIGRABOND Standard from SGL Carbon GmbH.

The hollow housing and/or the foil and/or wall member respectively SiC growth substrate formed by the carbon fiber composite material is a preferred embodiment of the present invention and preferably has a tensile strength above 50 MPa (cf. DIN IEC 60413/501) and/or a flexural strength above 50 MPa. This embodiment is beneficial since high tensile loads resulting from high temperature differences resulting from thick SiC crusts can be compensated.

According to a further preferred embodiment of the present invention a heating unit for non-electrically generation of heat is provided, wherein the heating unit is configured for heating the SiC growth substrate/s to a temperature above 1300°C and preferably between 1300°C and 2000°C or between 1300°C and 1800°C. This embodiment is beneficial since e.g., gas, in particular natural gas, H2 and/or biogas and/or methane, can be burned to generate heat. The flame, which results during burning gas, can be used to directly heat the wall member. Alternatively, the flame can be used to heat a heat transfer medium or to generate a heat transfer medium, which is guided to the wall member for heating the wall member. A heating unit which is based on burning gas causes significant smaller infrastructure cost, since no transistors, transformers, etc. are required. Furthermore, the costs for maintenance are smaller.

According to a further preferred embodiment of the present invention the heating unit forms a fluid guide means for guiding fluid heated to a temperature above 1300°C and preferably between 1300°C and 2000°C or between 1300°C and 1800°C for heating the wall member for heating the wall surface section. This embodiment is beneficial since heat distribution can be adjusted in a very precise manner in case a fluid is heated and circulated through a heat guide means, wherein the heat guide means is preferably formed by at least one pipe, wherein the pipe preferably comprises graphite or CFC-material or molybdenum.

According to a further preferred embodiment of the present invention the heating unit forms a fluid guide means for guiding a gas to at least one defined combustion space for burning the guided gas and thereby heating the wall member for heating the wall surface section. This embodiment is beneficial since the wall member can be heated very fast.

The above-mentioned object is also solved by a SiC production method, in particular for the production of 3C-SiC, according to claim 6. Said method preferably comprising the steps or at least the step: Providing a SiC production reactor, wherein the SiC production reactor comprises a process chamber, wherein the process chamber is at least surrounded by a bottom wall section, in particular a base plate or base plate wall section, a side wall section and a top wall section, a gas inlet unit for feeding one feed-medium or multiple feed-mediums into a reaction space of the process chamber for generating a source medium, wherein the gas inlet unit is coupled with at least one feed-medium source, wherein a Si and C feed-medium source is configured to provide at least Si and C, in particular SiCl3(CH3), and wherein a carrier gas feed-medium source provides a carrier gas, in particular H2, or wherein the gas inlet unit is coupled with at least two feed-medium sources, wherein a Si feed medium source is configured to provide at least Si and wherein a C feed medium source provides at least C, in particular natural gas, Methane, Ethane, Propane, Butane and/or Acetylene, and wherein a carrier gas medium source is configured to provide a carrier gas, in particular H2. The SiC production reactor preferably also comprises multiple SiC growth substrates, in particular more than 3 or 4 or 6 or 8 or 16 or 32 or 64 or up to 128 or up to 256, are arranged inside the process chamber for depositing SiC, wherein a first SiC growth substrate of said multiple SiC growth substrates comprises at least a first growth face section facing into a first directing and a second growth face section facing into a second direction, wherein the second direction is aligned less than 20°, in particular less than 10° or less than 5°, to the opposite direction of the first direction, wherein a second SiC growth substrate of said multiple SiC growth substrates comprises at least a third growth face section facing into the third direction, wherein the third direction is aligned less than 20°, in particular less than 10° or less than 5°, to the first direction and wherein the second SiC growth substrate comprises a fourth growth face section facing into a fourth direction, wherein a third SiC growth substrate of said multiple SiC growth substrates comprises at least a fifth growth face section facing into the fifth direction, wherein the fifth direction is aligned less than 20°, in particular less than 10° or less than 5°, to the third direction and wherein the third SiC growth substrate comprises a sixth growth face section facing into a sixth direction, wherein the fourth growth face section overlays in the first direction at least 50% of the first growth face section, wherein the size of the fourth growth face section is at least 80%, in particular more than 90% or more 95%, of the size of the first growth face section, wherein the sixth growth face section overlays in the fifth direction at least 50% of the third growth face section, wherein the size of the sixth growth face section is at least 80%, in particular more than 90% or more 95%, of the size of the third growth face section, and heating the multiple SiC growth substrates, feeding the one feed-medium or the multiple feed-mediums into the reaction space, depositing SiC on the first growth face section and on the second growth face section and on the third growth face section and on the fourth growth face section and on the fifth growth face section and on the sixth growth face section.

The above-mentioned object is also solved by a SiC production reactor according to claim 7. The SiC production reactor preferably comprises at least a process chamber, wherein the process chamber is at least surrounded by a bottom wall section, in particular a base plate or base plate wall section, a side wall section and a top wall section,
a gas inlet unit for feeding one feed-medium or multiple feed-mediums into a reaction space of the process chamber for generating a source medium. The at least one feed-medium source is preferably a Si and C feed-medium source, which is preferably configured to provide at least Si and C, in particular SiCl3(CH3), and wherein a carrier gas feed-medium source is preferably provided which is configured to provide a carrier gas, in particular H2. Alternatively the gas inlet unit is preferably coupled with at least two feed-medium sources, wherein the at least two feed-medium sources preferably comprise a Si feed medium source which is preferably configured to provide at least Si and wherein a C feed medium source is preferably configured to provide at least C, in particular natural gas, Methane, Ethane, Propane, Butane and/or Acetylene, and wherein preferably a carrier gas medium source is provided which preferably provides a carrier gas, in particular H2. At least one SiC growth substrate surface is formed inside the process chamber by a wall surface section. The SiC production reactor preferably also comprises a heating unit for non-electrically generation of heat is provided, wherein the heating unit is configured for heating the SiC growth substrate surface to a temperature above 1300°C and preferably between 1300°C and 2000°C or between 1300°C and 1800°C.

This solution is beneficial since the infrastructure costs for electronic components like transformers, transistors, etc. can be significantly reduced. Furthermore, costs for maintenance are also smaller in case the heating unit causes a non-electrically generation of heat.

According to a further preferred embodiment of the present invention the heating unit is at least sectionally surrounded by a wall member forming the wall surface section. This embodiment is beneficial since the heating unit preferably transfers heat via radiation to the wall member. However, it is alternatively or additionally possible that the heating unit contacts the wall member for transferring heat via heat conduction to the wall member.

According to a further preferred embodiment of the present invention the wall surface section is part of the side wall section and/or top wall section or part of a wall member surrounded by the side wall section and top wall section. This embodiment is beneficial since multiple wall sections, in particular facing in different directions, can be heated and used for deposition of SiC. Thus, one or multiple heating unit/s can be operated at the same time to heat different surface sections.

According to a further preferred embodiment of the present invention the heating unit forms a fluid guide means for guiding fluid heated to a temperature above 1300°C and preferably between 1300°C and 2000°C or between 1300°C and 1800°C for heating the wall member for heating the wall surface section. This embodiment is beneficial since the heat distribution can be controlled precisely. Furthermore, the heated fluid stores some heat and allows compensation of gas flow interruption.

According to a further preferred embodiment of the present invention the heating unit forms a fluid guide means for guiding a gas to at least one defined combustion space for burning the guided gas and thereby heating the wall member for heating the wall surface section. This embodiment is beneficial since the temperature of the wall member can be increased rapidly, in particular in less than 5min or less than 2min or less than 1min.

The above-mentioned object is also solved by a SiC production method, in particular for the production of 3C-SiC, according to claim 12. The SiC production method preferably comprises at least the steps: Providing a SiC production reactor, wherein the SiC production reactor comprises a process chamber, wherein the process chamber is at least surrounded by a bottom wall section, in particular a base plate or base plate wall section, a side wall section and a top wall section and a gas inlet unit for feeding one feed-medium or multiple feed-mediums into a reaction space of the process chamber for generating a source medium. The gas inlet unit is preferably coupled with at least one feed-medium source, wherein a Si and C feed-medium source is configured to provide at least Si and C, in particular SiCl3(CH3), and wherein a carrier gas feed-medium source provides a carrier gas, in particular H2, or wherein the gas inlet unit is coupled with at least two feed-medium sources, wherein a Si feed medium source is configured to provide at least Si and wherein a C feed medium source provides at least C, in particular natural gas, Methane, Ethane, Propane, Butane and/or Acetylene, and wherein a carrier gas medium source is configured to provide a carrier gas, in particular H2. Preferably at least one SiC growth substrate surface is formed inside the process chamber by a wall surface section. The method also comprises the step of providing a heating unit for non-electrically generation of heat. The method preferably also comprises the step of heating the at least one SiC growth substrate surface with the heating unit to a temperature above 1300°C and preferably between 1300°C and 2000°C or between 1300°C and 1800°C and the step of feeding the one feed-medium or the multiple feed-mediums into the reaction space, and the step of depositing SiC on the at least one SiC growth substrate surface.

The gas inlet unit is according to a further preferred embodiment of the present invention coupled with at least one feed-medium source, wherein the one feed-medium source is a Si and C feed-medium source, wherein the Si and C feed-medium source provides at least Si and C, in particular SiCl3(CH3), and wherein a carrier gas feed-medium source provides a carrier gas, in particular H2, or wherein the gas inlet unit is coupled with at least two feed-medium sources, one of the two feed-medium sources is a Si feed medium source, wherein the Si feed medium source provides at least Si, in particular a Si gas according to the general formula SiH4-y Xy (X=[Cl, F, Br, J] und y= [0..4], and another one of the two feed-medium sources is a C feed medium source, wherein the C feed medium source provides at least C, in particular natural gas, Methane, Ethan, Propane, Butane and/or Acetylene, and wherein a carrier gas medium source provides a carrier gas, in particular H2.

Alternatively the first feed medium is a Si feed medium, in particular a Si gas according to the general formula SiH4-y Xy (X=[Cl, F, Br ,J] und y= [0..4], wherein the gas inlet unit is coupled with at least one feed-medium source, wherein a Si and C feed-medium source provides at least Si and C, in particular SiCl3(CH3) and wherein a carrier gas feed-medium source provides a carrier gas, in particular H2, or wherein the gas inlet unit is coupled with at least two feed-medium sources, wherein a Si feed medium source provides at least Si, in particular the Si feed medium source provides a first feed medium, wherein the first feed medium is a Si feed medium, in particular a Si gas according to the general formula SiH4-y Xy (X=[Cl, F, Br, J] und y= [0..4], and wherein a C feed medium source provides at least C, in particular the C feed medium source provided a second feed medium, wherein the second feed medium is a C feed medium, in particular natural gas, Methane, Ethan, Propane, Butane and/or Acetylene, and wherein a carrier gas medium source provides a third feed medium, wherein the third feed medium is a carrier gas, in particular H2.

Natural gas preferably defines a gas having multiple components, wherein the largest component is methane, in particular more than 50% [mass] is methane and preferably more than 70%[mass] is methane and highly preferably more than 90%[mass] is methane and most preferably more than 95%[mass] or more than 99%[mass] is methane.

Thus, the SiC production reactor respectively the CVD SiC apparatus is preferably also equipped with a feed gas unit respectively a medium supply unit for feeding the feed gas to the gas inlet unit. The feed gas unit respectively medium supply unit ensures the feed gases are heated to the right temperature and mixed in the right ratios before they are pumped into the CVD reactor respectively SiC production reactor, in particular SiC PVT source material production reactor. The feed gas unit respectively medium supply unit begins with pipes and pumps which transport feed gases from their respective sources, in particular storage tanks, to the proximity of the CVD reactor respectively SiC production reactor, in particular SiC PVT source material production reactor. Here the mass flowrate of preferably each feed gas is preferably controlled by a separate mass flow meter connected to an overall process control unit so that the correct ratio of the various feed gases can be achieved. The separate feed gases are then preferably mixed in a mixing unit, in particular of the medium supply unit, and pumped into the CVD reactor respectively SiC production reactor, in particular SiC PVT source material production reactor, via the gas inlet unit, in particular via multiple gas inlet ports of the gas inlet unit. Preferably the feed gas unit respectively medium supply unit is able to mix three feed gases including an Si-bearing gas such as STC and/or TCS, a C-bearing gas such as methane, and a carrier gas such as H. In another preferred embodiment of the invention, there is a feed gas that bears both Si and C such as MTCS and the feed gas unit mixes two gases instead of three, namely MTCS and H. It should be noted that STC, TCS, and MTCS are liquid at room temperature. As such a preheater can be required upstream of the gas inlet unit, in particular upstream of the feed gas unit respectively medium supply unit to first heat these feed liquids so that they become feed gases ready for mixing with the other feed gases.

Preferably the gases are mixed such that there is a 1:1 atomic ratio between Si and C. In some cases, it may be more preferably to mix the gases such that there is a different atomic ratio between the Si and the C. Sometimes it is desirable to maintain the deposition surfaces at the higher end of the deposition temperature range of 1300°C to 2000°C, in particular 1300 to 1600°C, to achieve a faster deposition rate. However, in such a condition there is the possibility of excess C deposition in the SiC. This can be moderated by mixing the feed gases such that the Si:C ratio is higher than 1:1, preferably 1:1.1 or 1:1.2, or 1:1.3.

Conversely, sometimes it is desirable to maintain the deposition surfaces at the lower end of the deposition temperature range to achieve a slow stress-free deposition. In such a condition there is the possibility of excess Si deposition in the SiC. This can be moderated by mixing the feed gases such that the Si:C ratio is lower than 1:1, preferably 1:0.9, or 1:0.8, or 1:0.7.

A further important consideration for the feed gas mixture is the atomic ratio of H to Si and C. Excess H can dilute the Si and C and reduce the deposition rate. It can also increase the volume of vent gases exiting the CVD reactor respectively SiC production reactor, in particular SiC PVT source material production reactor, and complicate any treatment and recycling of these vent gases. On the other hand, insufficient H can retard the chemical reaction chain that results in the deposition of SiC. The molar ratio of H₂ to Si is preferably in the range of 2:1 to 10:1 and more preferably between 4:1 and 6:1.

A control unit for setting up a feed medium supply of the one feed-medium or the multiple feed-mediums into the process chamber is provided according to a further preferred embodiment of the present invention, wherein the control unit is configured to set up the feed medium supply between a minimum amount of feed medium supply [mass] per min. and a maximum amount of feed medium supply [mass] per min., wherein the minimum amount of feed medium supply [mass] per min. corresponds to a deposited minimum amount of Si [mass] and a minimum amount of C [mass] at a defined mass growth rate, wherein the defined mass growth rate is larger than 0.1 g per hour and per cm2 of the SiC growth surface, wherein the maximum amount of feed medium supply per min is up to 30% [mass] or to 20% [mass] or up to 10% [mass] or up to 5% [mass] or up to 3% [mass] higher compared to the minimum amount of feed medium supply. This embodiment is beneficial since the feed medium supply can be controlled in dependency of the desired SiC conditions.

The control unit is according to a further preferred embodiment of the present invention configured to control heating the SiC growth substrate/s to maintain the surface temperature of the SiC growth substrate/s or to set up the surface temperature of the deposited SiC. This embodiment is beneficial since the deposition of the SiC can be maintained by setting up the required temperature conditions.

The control unit is according to a further preferred embodiment of the present invention configured to control the heating of the SiC growth substrate/s and the amount of feed medium supply for at least one hour and preferably for at least two hours or four hours or six hours to continuously deposit SiC with the defined surface growth rate and/or with a defined radial growth rate. This embodiment is beneficial since large SiC solids can be generated.

The control unit is according to a further preferred embodiment of the present invention a hardware arrangement configured to control the heating unit, wherein predefined modification of the heating unit can be caused within a first defined time span from the start of a production run. This embodiment is beneficial since the hardware can be adapted to a defined process, thus additional sensors are not necessary. The first-time span is preferably one hour or more than one hour or up to 60% of the duration of the production run or up to 80% of the duration of the production run or up to 90% of the duration of the production run or up to 100% of the duration of the production run. The hardware arrangement is preferably configured to modify the amount of feed medium supply, wherein modification of the amount of feed medium supply within a second defined time span from the start of a production run is predefined, wherein the second time span is one hour or more than one hour or up to 60% of the duration of the production run or up to 80% of the duration of the production run or up to 90% of the duration of the production run or up to 100% of the duration of the production run.

At least one sensor is according to a further preferred embodiment of the present invention provided, wherein the sensor is coupled with the control unit to provide sensor signals or sensor data to the control unit, wherein the control unit controls the heating unit and the amount of feed medium supply in dependency of the sensor signals or sensor data of the at least one sensor, wherein the at least one sensor is a temperature sensor for monitoring the surface temperature of at least one of the substrates. At least one temperature sensor is preferably a camera, in particular an IR camera, wherein preferably multiple temperature sensors are provided, wherein the number of temperature sensors corresponds to the number of SiC growth substrates, wherein per 10 SiC growth substrates at least 1, in particular 2 or 5 or 10 or 20, temperature sensor is provided or wherein per 5 SiC growth substrates at least 1, in particular 2 or 5 or 10 or 20, temperature sensor is provided or wherein per 2 SiC growth substrates at least 1, in particular 2 or 5 or 10 or 20, temperature sensor is provided, wherein the temperature sensor preferably outputs temperature sensor signals or temperature sensor data representing a measured temperature, in particular surface temperature. This embodiment is beneficial since the conditions inside the SiC production reactor can be immediately adjusted.

At least one substrate thickness measuring sensor is according to a further preferred embodiment of the present invention provided, wherein the substrate thickness measuring sensor is preferably an IR camera for determining substrate thickness growth, wherein the substrate thickness measuring sensor preferably outputs thickness measuring signals or thickness measuring data representing a measured substrate thickness or a variation of a measured substrate thickness and/or a resistance determination means for determining electrical resistance variation for determining substrate thickness growth, wherein the substrate thickness measuring sensor preferably outputs thickness measuring signals or thickness measuring data representing a measured substrate thickness or a variation of a measured substrate diameter. This embodiment is beneficial since in dependency of the measured data or values parameter like heating or feed medium supply can be amended, in particular increased.

One valve or multiple vales is/are according to a further preferred embodiment of the present invention provided, wherein the one or multiple valves are configured to be actuated in dependency of the measured temperature, in particular in dependency of the temperature sensor signals or temperature sensor data and/or wherein the one or multiple valves are configured to be actuated in dependency of the measured substrate diameter, in particular in dependency of the thickness measuring signals or thickness measuring data. The one valve or the multiple valves can be part of the gas inlet unit. This embodiment is beneficial since a feed medium flow and/or vent gas flow can be controlled. Thus, the control unit is according to a further preferred embodiment of the present invention configured to increasing the electrical energizing of the at least one SiC growth substrate over time, in particular to heat a surface of the deposited SiC to a temperature between 1300°C and 1800°C

Thus, the control unit is preferably configured to receive the temperature sensor signals or temperature sensor data and/or the thickness measuring signals or thickness measuring data and to process the temperature sensor signals or temperature sensor data and/or the thickness measuring signals or thickness measuring data and/or to control the one or multiple vales and/or the energy supply unit.

The control unit is according to a further preferred embodiment of the present invention configured to control feed-medium flow and temperature of the surface of the deposited SiC for depositing SiC at the set deposition rate, in particular perpendicular deposition rate, for more than 2hours, in particular for more or up to 3 hours or for more or up to 5 hours or for more or up to 8 hours or preferably for more or up to 10 hours or highly preferably for more or up to 15 hours or most preferably for more or up to 24 hours or up to 72h or up to 100h. This embodiment is beneficial since a large amount of SiC can be grown.

The base plate comprises according to a further preferred embodiment of the present invention at least one cooling element, in particular a base cooling element, for preventing heating the base plate above a defined temperature and/or the side wall section comprises at least one cooling element, in particular a bell jar cooling element, for preventing heating the side wall section above a defined temperature and/or the top wall section comprises at least one cooling element, in particular a bell jar cooling element, for preventing heating the top wall section above a defined temperature.

This embodiment is beneficial since the present invention discloses a CVD SiC apparatus for large volume commercial production of ultrapure bulk CVD SiC. The central equipment in the CVD SiC apparatus is the CVD unit respectively CVD reactor respectively SiC production reactor, in particular SiC PVT source material production reactor. The CVD reactor respectively SiC production reactor, in particular SiC PVT source material production reactor, preferably comprises a cooling element, in particular a double walled fluid, in particular water or oil, cooled lower housing respectively baseplate and a double walled liquid cooled upper housing respectively bell jar. The inner walls of the baseplate and in particular the bell jar are preferably made of materials with service temperatures compatible with the operating temperatures of the CVD reactor respectively SiC production reactor, in particular SiC PVT source material production reactor. In particular, the inner wall of the bell jar can be made from stainless steel. Preferably, this inner wall is additionally or alternatively coated with a reflective coating such as preferably silver or preferably gold to reflect back radiant energy and minimize heat losses and therefore electricity costs. The bell jar and/or the base plate are preferably made of stainless steel that withstands high temperatures. However, current high temperature steels with additions of chromium, nickel, cerium or yttrium only withstand temperatures up to 1300°C (in air). As an example, the steel EN 1.4742 (X10CrAISi18) is heat resistant up to temperatures of 1000°C. In another example the alloy steel EN 2.4816 (UNS N06600) withstands temperature of 1250°C, melts above 1370°C, however its tensile strength drops to less than 10% of its room temperature value at temperatures above 1100°C. Therefore, none of these steels can withstand the enormous temperature required for SiC absorption of more than 1300°C.

It is therefore beneficial to provide a cooling element to reduce the temperature of the bell jar and/or the base plate to a level that is acceptable for the usage of high temperature stainless steel.

The cooling element is according to a further preferred embodiment of the present invention an active cooling element.

The base plate and/or side wall section and/or top wall section comprises according to a further preferred embodiment of the present invention a cooling fluid guide unit for guiding a cooling fluid, wherein the cooling fluid guide unit is configured limit heating of the base plate and/or side wall section and/or top wall section to a temperature below 1300°C. This embodiment is beneficial since a metal, in particular steel bell jar can be provided. A steel bell jar is beneficial since it can be produced significant larger compared to quartz bell jars.

A bottom wall section, in particular a base plate or base plate wall section, and/or side wall section and/or top wall section sensor unit is provided according to a further preferred embodiment of the present invention to detect temperature of the base plate and/or side wall section and/or top wall section and to output a temperature signal or temperature data, and a fluid forwarding unit is provided for forwarding the cooling fluid through the fluid guide unit. This embodiment is beneficial since a continuous cooling can take place without loss or contamination of the cooling fluid and/or the process chamber.

The fluid forwarding unit is according to a further preferred embodiment of the present invention configured to be operated in dependency of the temperature signal or temperature data provided by the base plate and/or side wall section and/or top wall section sensor unit. This embodiment is beneficial since metal impurities can be avoided in case the bell jar and/or base plate are operated at temperatures below 1000°C and preferably below 800°C and highly preferably below 400°C respectively in case the bell jar and/or base plate are cooled to temperatures below 1000°C and preferably below 800°C and highly preferably below 400°C.

The cooling fluid is according to a further preferred embodiment of the present invention oil or water, wherein the water preferably comprises at least one additive, in particular corrosion inhibiter/s and/or antifouling agent/s (biocides). This embodiment is beneficial since the cooling liquid can be modified to avoid defects or contaminations of the SiC production reactor.

The cooling element is according to a further preferred embodiment of the present invention a passive cooling element. This embodiment is beneficial since a passive cooling element does not require constant monitoring.

The cooling element is according to a further preferred embodiment of the present invention at least partially formed by a polished steel surface of the base plate, the side wall section and/or the top wall section. The cooling element is according to a further preferred embodiment of the present invention a coating, wherein the coating is formed above the polished steel surface and wherein the coating is configured to reflect heat. The coating is according to a further preferred embodiment of the present invention a metal coating or a comprises metal, in particular silver or gold or chrome, or alloy coating, in particular a CuNi alloy. The emissivity of the polished steel surface and/or of the coating is according to a further preferred embodiment of the present invention below 0.3, in particular below 0.1 or below 0.03. This embodiment is beneficial since due to the polished surface and/or the coating a high amount of heat radiation can be reflected back to the SiC growth surface.

Thus, at least one section of the bell jar surface and/or at least one section of the base unit surface comprises according to a further preferred embodiment of the present invention a coating, in particular a reflective coating, wherein the section of the bell jar surface and/or the section of the base unit surface delimits the reaction space, wherein the coating is a metal coating, in particular comprises or consists of gold, silver, aluminum and/or platinum and/or wherein the coating is configured to reflect at least 2% or at least 5% or at least 10% or at least 20% of the radiant energy radiated during one production run onto the coating.

The base plate comprises according to a further preferred embodiment of the present invention at least one active cooling element and one passive cooling element for preventing heating the base plate above a defined temperature and/or the side wall section comprises at least one active cooling element and one passive cooling element for preventing heating the side wall section above a defined temperature and/or the top wall section comprises at least one active cooling element and one passive cooling element for preventing heating the top wall section above a defined temperature.

The side wall section and the top wall section are formed according to a further preferred embodiment of the present invention by a bell jar, wherein the bell jar is preferably movable with respect to the base plate. More than 50% [mass] of the side wall section and/or more than 50% [mass] of the top wall section and/or more than 50% [mass] of base plate is according to a further preferred embodiment of the present invention made of metal, in particular steel. This embodiment is beneficial since large steel bell jars can be manufactured causing a significant increase in process chamber volume and therefore in potential SiC material. Thus a bell jar is preferably provided, wherein the bell jar comprises according to a further preferred embodiment of the present invention a contact region for forming an interface with the base unit, wherein the interface is sealed against leakage of gaseous species, wherein the bell jar comprises a bell jar cooling unit, wherein the bell jar cooling element forms at least one channel or trench or recess for holding or guiding a bell jar cooling liquid, wherein the bell jar cooling element is configured to cool at least one section of the bell jar and preferably the entire bell jar below a defined temperature respectively to remove a defined amount of heat per min during the production run. The bell jar cooling element and/or base plate cooling element is preferably controlled by the control unit. Additionally, or alternatively the bell jar cooling element and/or base cooling element are coupled with each other to form one major cooling unit.

The base unit comprises according to a further preferred embodiment of the present invention at least one base cooling element for cooling the base unit, wherein the base cooling element forms at least one channel or trench or recess for holding or guiding a base cooling liquid.

The medium supply unit is according to a further preferred embodiment of the present invention configured to feed the one feed-medium or multiple feed-mediums at a pressure of more than 1 bar, in particular of more than 1.2bar or preferably of more than 1.5bar or highly preferably of more than 2bar or 3bar or 4bar or 5bar respectively of up to 10 bar or up to 20 bar, into the process chamber. Additionally, or alternatively the medium supply unit is according to a further preferred embodiment of the present invention configured to feed the one feed-medium or multiple feed-mediums and a carrier gas at a pressure of more than 1 bar, in particular of more than 1.2bar or 1.5bar or 2bar or 3bar or 4bar or 5bar, into the process chamber. This embodiment is beneficial since the material density is high inside the process chamber, thus a high amount of Si and C material reaches the SiC growth surface and therefore causes an enhanced SiC growth.

The inlet unit comprises according to a further preferred embodiment of the present invention multiple orifices for setting up a turbulent gas flow inside the process chamber, in particular in a distance of less than 20mm or less than 10mm or less than 2mm to the surface of the SiC growth substrate or to the surface of the SiC deposited on the SiC growth substrate. Since the surface of the deposited SiC growth, in particular continuously growth, the region wherein turbulent flow has to be maintained can change. This embodiment is beneficial since due to the turbulent flow the speed of deposition can be increased, since more Si and C material reaches the SiC growth substrate surface respectively the SiC growth surface.

The control unit is according to a further preferred embodiment of the present invention configured to control the medium supply unit to feed the one feed-medium or the multiple feed-mediums into the process chamber, wherein the one feed-medium or the multiple feed-mediums comprise the following molar ratio: Si:C, wherein Si =1 and C=0.8 to 1.1 or wherein the one feed-medium or the multiple feed-mediums comprise the following atomic ratio: Si:C, wherein Si =1 and C=0.8 to 1.1. This embodiment is beneficial since the desired material ratio can be controlled and set. Thus, a control unit for setting up a feed medium supply of the one feed-medium and the carrier gas into the process chamber is provided, wherein the control unit is preferably configured to control the medium supply unit to feed the one feed-medium into the process chamber in a defined molar ratio and/or defined atomic ratio, wherein the one feed-medium and the carrier gas comprise the following defined molar ratio: Si:H, wherein Si =1 and H=2 to 10, preferably 5 to 10 and highly preferably 5 to 7, or wherein the one feed-medium and the carrier gas comprise the following defined atomic ratio: Si:H, wherein Si =1 and H=2 to 10, preferably 5 to 10 and highly preferably 5 to 7 or a control unit for setting up a feed medium supply of the multiple feed-mediums into the process chamber, wherein the control unit is configured to control the medium supply unit to feed the multiple feed-mediums into the process chamber in a defined molar ratio and/or defined atomic ratio, wherein the multiple feed-mediums comprise the following defined molar ratio: Si:C, wherein Si =1 and C=0.8 to 1.1 or wherein the multiple feed-mediums comprise the following defined atomic ratio: Si:C, wherein Si =1 and C=0.8 to 1.1.

The Si and C feed-medium source is according to a further preferred embodiment of the present invention coupled with at least one Si and C feed-medium orifice of the inlet unit and the carrier gas feed-medium source is coupled with at least one carrier gas orifice of the inlet unit, wherein the Si and C feed-medium orifice and the carrier gas orifice preferably differ from each other or the Si and C feed-medium source and the carrier gas feed-medium source are coupled with at least one common mixing and/or guiding element, in particular a pipe, wherein the at least one common mixing and/or guiding element is coupled with at least one orifice of the inlet unit.

A Si and C supply device is according to a further preferred embodiment of the present invention provided for feeding the Si and C feed medium from the Si and C feed-medium source via the at least one orifice of the gas inlet unit into the reaction space and/or a carrier gas supply device is provided for feeding the carrier gas feed medium from the carrier gas feed-medium source via the at least one orifice of the inlet unit into the reaction space and/or a feed-medium supply device is provided for a mixture of the Si and C feed-medium and the carrier gas feed-medium from the common mixing and/or guiding element via the at least one orifice of the inlet unit into the reaction space.

Alternatively a Si feed medium source is according to a further preferred embodiment of the present invention coupled with at least one Si feed-medium source orifice of the inlet unit and wherein the C feed medium source is coupled provides at least one C feed-medium source orifice of the inlet unit and wherein a carrier gas medium source is coupled with at least one carrier gas feed-medium source orifice of the inlet unit, wherein the Si feed-medium source orifice and/or the C feed-medium source orifice and/or the carrier gas feed-medium source orifice differ from each other or the Si feed medium source and the C feed medium source are coupled with at least one common mixing and/or guiding element, in particular a pipe, wherein the at least one common mixing and/or guiding element is coupled with at least one orifice of the inlet unit or the Si feed medium source and the carrier gas feed-medium source are coupled with at least one common mixing and/or guiding element, in particular a pipe, wherein the at least one common mixing and/or guiding element is coupled with at least one orifice of the inlet unit or the C feed medium source and the carrier gas feed-medium source are coupled with at least one common mixing and/or guiding element, in particular a pipe, wherein the at least one common mixing and/or guiding element is coupled with at least one orifice of the inlet unit or the Si feed medium source and the C feed medium source and the carrier gas feed-medium source are coupled with at least one common mixing and/or guiding element, in particular a pipe, wherein the at least one common mixing and/or guiding element is coupled with at least one orifice of the inlet unit.

A Si supply device is according to a further preferred embodiment of the present invention provided for feeding the Si feed medium from the Si feed-medium source via the at least one orifice of the inlet unit into the reaction space and/or a C supply device is provided for feeding the C feed medium from the C feed-medium source via the at least one orifice of the inlet unit into the reaction space and/or a carrier gas supply device is provided for feeding the carrier gas from the carrier gas feed-medium source via the at least one orifice of the inlet unit into the reaction space. The Si supply device and/or the C supply device and/or the carrier gas supply device is preferably a pump, in particular a pressure pump.

At least one outlet unit respectively vent gas outlet for removing gas from the reaction space is provided according to a further preferred embodiment of the present invention as part of the bell jar and/or as part of the base unit. This embodiment is beneficial since the used gas can be conducted out of the process chamber, thus the amount of Si and C is less affected by the presence of not vented vent gas. A pump device is according to a further preferred embodiment of the present invention coupled with the outlet unit for removing gas from the reaction space, wherein the pump device is preferably a vacuum pump.

The Si feed-medium source is according to a further preferred embodiment of the present invention configured to provide the Si feed-medium with a purity of at least 6N, in particular 7N or preferably 8N or highly preferably 9N, the C feed-medium source is configured to provide the C feed-medium with a purity of at least 6N, in particular 7N or preferably 8N or highly preferably 9N or the Si and C feed-medium source is configured to provide the Si and C feed-medium with a purity of at least 6N, in particular 7N or preferably 8N or highly preferably 9N and the carrier gas feed-medium source is configured to provide the carrier gas feed-medium with a purity of at least 6N, in particular 7N or preferably 8N or highly preferably 9N. Thus, introducing at least a first feed-medium, in particular a first source gas, into the process chamber can take place, said first feed medium comprises Si, wherein the first-feed medium has a purity which excludes at least 99.99999% (ppm wt) of the substances B, Al, P, Ti, V, Fe, Ni, in particular of one or preferably multiple or highly preferably a majority or most preferably all of the substances B, Al, P, Ti, V, Fe, Ni, and introducing at least a second feed-medium, in particular a second source gas, into the process chamber, the second feed medium comprises C, wherein the second-feed medium has a purity which excludes at least 99.99999% (ppm wt) of the substances B, Al, P, Ti, V, Fe, Ni, in particular of one or preferably multiple or highly preferably a majority or most preferably all of the substances B, Al, P, Ti, V, Fe, Ni, and introducing a carrier gas, wherein the carrier gas has a purity which excludes at least 99.99999% (ppm wt) of the substances B, Al, P, Ti, V, Fe, Ni, in particular of one or preferably multiple or highly preferably a majority or most preferably all of the substances B, Al, P, Ti, V, Fe, Ni, or introducing one feed-medium in particular a source gas, into a process chamber, said feed medium comprises Si and C, wherein the feed medium has a purity which excludes at least 99.99999% (ppm wt) of the substances B, Al, P, Ti, V, Fe, Ni, in particular of one or preferably multiple or highly preferably a majority or most preferably all of the substances B, Al, P, Ti, V, Fe, Ni, and introducing a carrier gas, wherein the carrier gas has a purity which excludes at least 99.99999% (ppm wt) of the substances B, Al, P, Ti, V, Fe, Ni, in particular of one or preferably multiple or highly preferably a majority or most preferably all of the substances B, Al, P, Ti, V, Fe, Ni. Thus, present invention discloses a CVD reactor for the production of SiC source material that is at least 8N or preferably 9N pure when initially manufactured and is preferably provided in a granular or solid form factor that minimizes subsequent surface contamination during handling and use. This ultrapure SiC source material (UPSiC) is made by the CVD reactor respectively process wherein the feed gases used can be purified to extremely high levels using effective techniques such as distillation. The SiC respectively PVT source material SiC, in particular UPSiC, is typically first deposited in the form of long thick rods and then disaggregated, in particular cut or comminuted, to shapes or sizes suitable for use in PVT crucibles. The comminution equipment is preferably made of material that do not contaminate the SiC and there is also the possibility of a further acid etching step to remove fines and ensure surface purity. This embodiment is beneficial since large and very pure particles can be produced which have advantageous sublimation properties. In case an etching step is carried out only a few atom layers (less than 1 µm, compared to 10-50 µm in Si etching) will be removed, in particular by HF/HNO3. This is beneficial since due to the etching the bluish-brownish color after annealing can be removed. Additionally, or alternatively the oxide layer can also be removed with an acidic pickling acid, e.g., consisting of HCl:HF:H2O2 and/or different acid mechanism.

Chemical vapor deposition occurs when the deposition substrates respectively SiC growth substrates are heated to the deposition temperature range and the feed gas mixture is introduced into the CVD reactor respectively SiC production reactor, in particular SiC PVT source material production reactor. When the feed gas mixture contacts the heated deposition substrate the energy provided initiates a series of forward and backward chemical reactions the net result of which is deposition of solid SiC on the deposition substrate. In the case where the feed gas mixture includes STC and methane, the net reaction can be summarized as follows:

SiCl4 + CH4 = SiC + 4HCl

It should be noted that not every Si-bearing molecule and not every C-bearing molecule comes into contact with the deposition surfaces and undergoes the deposition reaction. Thus, it is preferred to pump in the feed gases at a higher rate than they depositing as SiC on the substrates. For example, if X moles of SiC are being deposited per square centimeter of deposition surface every hour, then it may be necessary to pump into the CVD reactor respectively SiC production reactor, in particular SiC PVT source material production reactor, AX moles of Si and AX moles of C every hour, where A is in the range between 8 and 10. The lower that A is the more efficient the conversion efficiency is from feed gas to deposited SiC. This efficiency is improved by optimizing the gas flow inside the CVD reactor respectively SiC production reactor, in particular SiC PVT source material production reactor, to maximize the contacting of the feed gas mixture with the deposition surfaces.

The interface between the bell jar and the base unit comprises according to a further preferred embodiment of the present invention a sealing, wherein the sealing is configured to withstand pressure above 1bar, in particular above 2bar or above 5 bar and highly preferably between 1 and 20 bar. This embodiment is beneficial since a high feed medium density can be generated inside the process chamber causing a beneficial Si and C supply to the SiC growth substrate.

The bell jar, in particular the surface of the bell jar, is according to a further preferred embodiment of the present invention delimiting the reaction space, and/or the base unit, in particular the surface of the base plate delimiting the reaction space, is configured to withstand chemical treatments, in particular caustic soda, in particular for at least 30 seconds or for at least 60 seconds or for at least 5 min. This embodiment is beneficial since the bell jar can be cleaned respectively optimized for reuse.

The SiC growth substrate is according to a further preferred embodiment of the present invention configured to hold a SiC solid which has a mass of more than 1kg, in particular of more or up to 5kg or preferably of more or up to 50kg or highly preferably of more or up to 200kg and most preferably of more or up to 500kg, and a thickness of at least 1cm, in particular of more or up to 2cm or preferably of more or up to 5cm or preferably of more or up to 10cm or highly preferably of more or up to 20cm or most preferably of more or up to 50cm. This embodiment is beneficial since large quantities of SiC material respectively PVT source material can be produced.

The reaction space volume allows according to a further preferred embodiment of the present invention the production of one SiC solid or multiple SiC solids at the same time, wherein the SiC solid has a mass of more than 1kg, in particular of more or up to 5kg or preferably of more or up to 50kg or highly preferably of more or up to 200kg and most preferably of more or up to 500kg, and a thickness of at least 1cm, in particular of more or up to 2cm or preferably of more or up to 5cm or preferably of more or up to 10cm or highly preferably of more or up to 20cm or most preferably of more or up to 50cm or wherein multiple or all SiC solids have a mass of more than 1kg, in particular of more or up to 5kg or preferably of more or up to 50kg or highly preferably of more or up to 200kg and most preferably of more or up to 500kg, and a thickness of at least 1cm, in particular of more or up to 2cm or preferably of more or up to 5cm or preferably of more or up to 10cm or highly preferably of more or up to 20cm or most preferably of more or up to 50cm. This embodiment is beneficial since large quantities of SiC material respectively PVT source material can be produced.

During the deposition run, the feed gas mixture is preferably continually being pumped into the CVD reactor respectively SiC production reactor, in particular SiC PVT source material production reactor, and vent gas is preferably continually exiting the reactor. Because of the deposition reaction, the composition of the vent gas is considerably different than the feed gas mixture. First, as shown by the net deposition reaction, a significant amount of HCI is generated and present in the vent gas along with unreacted feed gases. Second, side reactions occur which cause the formation of other Si-bearing molecules. For example, if the feed gas mixture contains STC, then some TCS will be formed within the CVD reactor respectively SiC production reactor, in particular SiC PVT source material production reactor, as a side reaction and will exit in the vent gas.

In small volume production of SiC it may not be convenient to recycle the vent gas even though the conversion efficiency is relatively low and a large molar ratio of Si-bearing gas and C-bearing gas is used compared to SiC deposited along with a high molar ratio of H. Therefore, in one embodiment of the present invention, the vent gas is first sent to a scrubber where it is contacted with water to remove all Si-bearing compounds and HCI. Then the vent gas is sent to a flare where it is combusted with the assistance of natural gas. As a result, harmless and small quantities of CO2 are exhausted into the air. Meanwhile, the scrubber liquid is sent to recycling companies for further processing, utilization, and disposal.

A gas outlet unit for outputting vent gas and a vent gas recycling unit are provided according to a further preferred embodiment of the present invention, wherein the vent gas recycling unit is connected to the gas outlet unit, wherein the vent gas recycling unit comprises at least a separator unit for separating the vent gas into a first fluid and into a second fluid, wherein the first fluid is a liquid and wherein the second fluid is a gas, wherein a first storage and/or conducting element for storing or conducting the first fluid is part of the separator unit or coupled with the separator unit and wherein a second storage and/or conducting element for storing or conducting the second fluid is part of the separator unit or coupled with the separator unit. This embodiment is beneficial since source material costs can significantly be reduced. The separator unit is preferably operated at a pressure above 5bar and a temperature below -30°C. The vent gas is therefore preferably fed into the separation unit, which can be a cold distillation column, where the Si-bearing compounds condense from gas to liquid form and travel down the column and exit out the bottom while the remaining gases of H, HCI, and methane travel up the column and exit out the top. The liquid is the first fluid and preferably comprises predominantly HCI and Chlorosilanes with minor percentage of H2 and C-gas. The gas is the second fluid, preferably comprising predominantly H2 and C-gas with minor percentage of HCI and Chlorosilanes.

The vent gas recycling unit comprises according to a further preferred embodiment of the present invention a further separator unit for separating the first fluid into at least two parts, wherein the two parts are a mixture of chlorosilanes and a mixture of HCI, H2 and at least one C-bearing molecule, and preferably into at least three parts, wherein the three parts are a mixture of chlorosilanes and HCI and a mixture of H2 and at least one C-bearing molecule, wherein the first storage and/or conducting element connects the separator unit with the further separator unit. This embodiment is beneficial since the HCI and H2 and at least one C-bearing molecule can be directly feed into a process chamber of a SiC production reactor for the production of SiC material respectively PVT source material. The further separator unit is preferably configured to be operate at a pressure above 5bar and a temperature below -30°C and/or a temperature above 100°C.

The further separator unit is according to a further preferred embodiment of the present invention coupled with a mixture or chlorosilanes storage and/or conducting element and with a HCI storage and/or conducting element and with a H2 and C storage and/or conducting element.

In the context of the present invention "C" can be understood as "at least one C-bearing molecule", thus the H2 and C storage and/or conducting element can be alternatively understood as H2 and at least one C-bearing molecule storage and/or conducting element.

The mixture of chlorosilanes storage and/or conducting element forms according to a further preferred embodiment of the present invention a section of a mixture of chlorosilanes mass flux path for conducting the mixture of chlorosilanes into the process chamber. This embodiment is beneficial since the chlorosilanes can be used as mixture. Thus, it is not necessary to further process the mixture of chlorosilanes with respect to a separation of the individual chlorosilanes.

Thus, due to the present invention it is also possible to manufacture a SiC source material with at least 6N or preferably 7N or more preferably 8N in large scales, wherein the provided feed gases used are recycled back from vent gases of a first SiC source production reactor. This is achieved by measuring the atomic ratio of H to C in the mixture and providing an appropriate ratio of makeup H hydrogen and C-bearing gas to the CVD reactor along with the mixture such that the overall H to C molar ratio of hydrogen and carbon in the C-bearing gas is in the required range. Under the given conditions in both the CVD reaction and the subsequent cold distillation, any carbon is present as methane. Any side products derived from methane in the CVD reaction will have higher boiling points and been separated from the gas phase in the cold distillation. Methane can be quantified e.g., by inline or online measurement (PAT, process analytical techniques), such as flame ionization detector, infrared spectrometry in any style (e.g., FTIR or NIR) or cavity ring-down spectroscopy (with most sensitive detection limits), or any other inline or online analytical method, which provides results with the required accuracy within seconds. The hydrogen content can be calculated from the measured total mass flow of the gas mixture and the quantified methane concentration. Losses are preferably compensated to maintain the molar ratio of the original feed gas mixture. This embodiment is beneficial since due to the recycling of the vent gas the purity of the recycled Si, C and H2 is further increased, thus the purity of the produced SiC is even better.

A Si mass flux measurement unit for measuring an amount of Si of the mixture of chlorosilanes is provided according to a further preferred embodiment of the present invention as part of the mass flux path prior to the process chamber, in particular prior to a mixing device, and preferably as further Si feed-medium source providing a further Si feed medium. The mixture of chlorosilanes storage and/or conducting element forms according to a further preferred embodiment of the present invention a section of a mixture of chlorosilanes mass flux path for conducting the mixture of chlorosilanes into a further process chamber of a further SiC production reactor. This embodiment is beneficial since it can be very precisely controlled if a feed medium from a feed source or a feed medium from the recycling unit is used. Additionally, or alternatively feed medium from the feed source can be added to the feed medium from the recycling unit in case the feed medium of the recycling unit is not sufficient.

The H2 an C storage and/or conducting element forms according to a further preferred embodiment of the present invention a section of a H2 and C mass flux path for conducting the H2 and the at least one C-bearing molecule into the process chamber. It is possible that HCI is also present. A C mass flux measurement unit for measuring an amount of C of the mixture of H2 and the at least one C-bearing molecule is provided according to a further preferred embodiment of the present invention as part of the H2 and C mass flux path prior to the process chamber, in particular prior to a mixing device, and preferably as further C feed-medium source providing a further C feed medium. The H2 an C storage and/or conducting element forms according to a further preferred embodiment of the present invention a section of a H2 and C mass flux path for conducting the H2 and the at least one C-bearing molecule into a further process chamber of a further SiC production reactor. The second storage and/or conducting element forms according to a further preferred embodiment of the present invention a section of the H2 and C mass flux path for conducting the second fluid, which comprises H2 and at least one C-bearing molecule, into the process chamber, wherein the second storage and/or conducting element and the H2 an C storage and/or conducting element are preferably fluidly coupled. The second storage and/or conducting element forms according to a further preferred embodiment of the present invention a section of a further H2 and C mass flux path for conducting the second fluid, which comprises H2 and at least one C-bearing molecule, into the process chamber. A further C mass flux measurement unit for measuring an amount of C of the second fluid is provided according to a further preferred embodiment of the present invention as part of the further H2 and C mass flux path prior to the process chamber, in particular prior to a mixing device. This embodiment is beneficial since besides the usage of chlorosilanes also H2 and at least one C-bearing molecule are recycled and therefore the overall efficiency is increased.

The second storage and/or conducting element is coupled according to a further preferred embodiment of the present invention with a flare unit for burning the second fluid.

A first compressor for compressing the vent gas to a pressure above 5bar is according to a further preferred embodiment of the present invention provided as part of the separator unit or in a gas flow path between the gas outlet unit and the separator unit. A further compressor for compressing the first fluid to a pressure above 5bar is according to a further preferred embodiment of the present invention provided as part of the further separator unit or in a gas flow path between the separator unit and the further separator unit.

The further separator unit preferably comprises a cryogenic distillation unit, wherein the cryogenic distillation unit is according to a further preferred embodiment of the present invention preferably configured to be operated at temperatures between -180C° and -40C°.

This embodiment is beneficial since TCS has a boiling point of 31.8°C and STC has a boiling point of 57.7°C. With such low but substantially different boiling points, TCS and STC can be effectively and economically separated from each other and from any heavy contaminants such as trace metals by conventional distillation methods and apparatuses. On the other hand, purification of methane from N requires more complicated cryogenic distillation. The boiling point of methane is -161.6°C and the boiling point of N is -195.8°C. Therefore, a distillation column can to be operated at a temperature somewhere in between so that the methane is liquid and travels toward the bottom of the column and the nitrogen is gaseous and travels toward the top of the column.

A control unit for controlling fluid flow of a feed-medium or multiple feed-mediums is according to a further preferred embodiment of the present invention part of the SiC production reactor, wherein the multiple feed-mediums comprise the first medium, the second medium, the third medium and the further Si feed medium and/or the further C feed medium via the gas inlet unit into the process chamber is provided. The further Si feed medium preferably consists of at least 95% [mass] or at least 98% [mass] or at least 99% [mass] or at least 99,9% [mass] or at least 99,99% [mass] or at least 99,999% [mass] of a mixture of chlorosilanes. The further C feed medium preferably comprises the at least one C-bearing molecule, H2, HCI and a mixture of chlorosilanes, wherein the further C feed medium comprises of at least 3% [mass] or preferably at least 5% [mass] or highly preferably at least 10% [mass] of C respectively of the at least one C-bearing molecule and wherein the further C feed medium comprises up to 10% [mass] or preferably between 0.001% [mass] and 10%[mass], highly preferably between 1% [mass] and 5%[mass], of HCI and wherein the further C feed medium comprises more than 5% [mass] or preferably more than 10% [mass] or highly preferably more than 25% [mass] of H2 and wherein the further C feed medium comprises more than 0.01% [mass] and preferably more than 1% [mass] and highly preferably between 0.001% [mass] and 10%[mass] of the mixture of chlorosilanes.

A heating unit is according to a further preferred embodiment of the present invention arranged in fluid flow direction between the further separator unit and the gas inlet unit for heating the mixture of chlorosilanes to transform the mixture of chlorosilanes from a liquid form into a gaseous form.

According to another preferred embodiment of the present invention, the surface of the deposition element respectively SiC growth substrate is heated to a temperature in the range between 1450°C and 1700°C, in particular to a temperature in the range between 1500°C and 1600°C or between 1490°C and 1680°C.

This embodiment is advantageously since an environment is created in which very pure SiC can be deposited on the deposition element. In particular, it has been recognized that at too low temperatures the proportion of Si deposited on the deposition element increases and at too high temperatures the proportion of C deposited on the deposition element increases. In the temperature range mentioned, however, the SiC is at its purest.

According to another preferred embodiment of the present invention, the first source gas is introduced into the process chamber via a first supply means and the second source gas is introduced into the process chamber via a second supply means, or the first source gas and the second source gas are mixed prior to introduction into the process chamber and are introduced into the process chamber via a supply means, wherein the source gases are mixed in a molar ratio Si: C of Si=1 and C=0.8 to 1.1 and/or an atomic ratio Si:C of Si=1 and C=0.8 to 1.1 are introduced into the process chamber. This is further advantageous because it allows the Si:C = 1:1 ratio in the SiC solid material to be adjusted very precisely via the molar ratio of the two gases.

This embodiment is advantageous a gas composition is created in the processor chamber in which very pure SiC is deposited at the deposition element.

According to another preferred embodiment of the present invention, the carrier gas comprises H, wherein the source gases and the carrier gas are present in a molar ratio Si:C:H of Si=1 and C=0.8 to 1.1 and H=2-10, in particular in a molar ratio Si: C:H of Si=1 and C=0.9 to 1 and H=3-5, and/or an atomic ratio Si:C:H of Si=1 and C=0.8 to 1.1 and H=2-10, in particular in an atomic ratio Si:C:H of Si=1 and C=0.9 to 1 and H=3-5, are introduced into the process chamber.

During deposition, the atomic ratio or molar ratio shown below is preferably present: H2:SiCI4:CH4 = 5:1:1 alternatively H2:SiCI4:CH4 = 6:1:1 alternatively H2:SiCI4:CH4 = 7:1:1 alternatively H2:SiCI4:CH4 = 8:1:1 alternatively H2:SiCI4:CH4 = 9:1:1 alternatively H2:SiCI4:CH4 = 10:1:1.

Thus, the atomic ratio or molar ratio between H2:SiCI4:CH4 during deposition is preferably between 5:1:1 and 10:1:1.

Preferably, a set atomic ratio or molar ratio is kept constant during deposition, this can preferably also apply in the case of changing flow rates. Particularly preferably, the total pressure or the pressure in the process chamber is also kept constant during the deposition.

This embodiment is advantageous as a gas composition is created in the processor chamber and an advantageous gas transport is created in the process chamber, where thereby very pure SiC is deposited very fast at the deposition element.

According to another preferred embodiment of the present invention, the deposition rate is set in the range between 300µm/h and 2500µm/h, more particularly in the range between 350µm/h and 1200µm/h, more particularly in the range between 400µm/h and 1000µm/h, more particularly in the range between 420µm/h and 800µm/h.

This embodiment is advantageous, since the production of SiC material is much more favorably convertible.

According to another preferred embodiment of the present invention, the first source gas is SiCI4, SiHCl3 or SiCl4 and the second source gas is CH4 or C3H8, wherein preferably the first source gas is SiCl4 and the second source gas is CH4 or wherein preferably the first source gas is SiHCl3 and the second source gas is CH4 or wherein preferably the first source gas is SiCl4 and the second source gas is C3H8.

This embodiment is advantageous because these source gases enable optimal Si and C provision for deposition.

Preferably, the source gas or the source gases and/or the carrier gas have a purity which excludes at least 99.9999% (ppm wt) of impurities, in particular of the substances B, Al, P, Ti, V, Fe, Ni.

Thus, preferably less than 1ppm wt of impurities, in particular of the substances B, Al, P, Ti, V, Fe, Ni, is a component of the swelling gas or gases and/or of the carrier gas or less than 0.1ppm wt of impurities, in particular of the substances B, Al, P, Ti, V, Fe, Ni, is a component of the swelling gas or gases and/or of the carrier gas. of the swelling gases and/or of the carrier gas or less than 0.01 ppm wt of foreign substances, in particular of the substances B, Al, P, Ti, V, Fe, Ni, constituent of the swelling gas or of the swelling gases and/or of the carrier gas.

Particularly preferably, less than 1ppm wt of substance B is a constituent of the swelling gas or gases and/or of the carrier gas. Particularly preferably, less than 1ppm wt of substance Al is a constituent of the swelling gas or gases and/or of the carrier gas. Particularly preferably, less than 1ppm wt of substance P is a constituent of the swelling gas or gases and/or of the carrier gas. Particularly preferably, less than 1ppm wt of the substance Ti is a constituent of the source gas or gases and/or of the carrier gas. Particularly preferably, less than 1ppm wt of substance V is a constituent of the swelling gas or gases and/or of the carrier gas. Particularly preferably, less than 1 ppm wt of the substance Fe is a constituent of the swelling gas or gases and/or of the carrier gas. Particularly preferably, less than 1ppm wt of the substance Ni is a constituent of the swelling gas or gases and/or of the carrier gas.

Particularly preferably, less than 0.1 ppm wt of substance B is a constituent of the swelling gas or gases and/or of the carrier gas. Particularly preferably, less than 0.1ppm wt of substance Al is a constituent of the source gas or gases and/or of the carrier gas. Particularly preferably, less than 0.1 ppm wt of substance P is a constituent of the swelling gas or gases and/or of the carrier gas. Particularly preferably, less than 0.1 ppm wt of the substance Ti is a constituent of the source gas or gases and/or of the carrier gas. Particularly preferably, less than 0.1ppm wt of substance V is a constituent of the swelling gas or gases and/or of the carrier gas. Particularly preferably, less than 0.1 ppm wt of the substance Fe is a constituent of the source gas or gases and/or of the carrier gas. Particularly preferably, less than 0.1ppm wt of the substance Ni is a constituent of the source gas or gases and/or of the carrier gas.

Particularly preferably, less than 0.01ppm wt of substance B is a constituent of the source gas or gases and/or of the carrier gas. Particularly preferably, less than 0.01 ppm wt of substance Al is a constituent of the source gas or gases and/or of the carrier gas. Particularly preferably, less than 0.01ppm wt of substance P is a constituent of the source gas or gases and/or of the carrier gas. Particularly preferably, less than 0.01 ppm wt of the substance Ti is a constituent of the source gas or gases and/or of the carrier gas. Particularly preferably, less than 0.01ppm wt of substance V is a constituent of the source gas or gases and/or of the carrier gas. Particularly preferably, less than 0.01ppm wt of the substance Fe is a constituent of the source gas or gases and/or of the carrier gas. Particularly preferably, less than 0.01ppm wt of the substance Ni is a constituent of the source gas or gases and/or of the carrier gas. Also particularly preferably, less than 1ppm wt of the substance Nitrogen (N) is a constituent of the source gas or gases and/or of the carrier gas.

According to a further preferred embodiment of the present invention, a temperature measuring device, in particular a pyrometer, is used to measure the surface temperature of the deposition element. Preferably, the temperature measuring device outputs a temperature signal and/or temperature data. Particularly preferably, a control device modifies, in particular increases, the electrical loading of the separator element as a function of the temperature signal and/or the temperature data.

According to a further preferred embodiment of the present invention, the temperature measuring device performs temperature measurements and outputs temperature signal and/or temperature data at time intervals of less than 5 minutes, in particular less than 3 minutes or less than 2 minutes or less than 1 minute or less than 30seconds. Preferably, a target temperature or a target temperature range is defined. The control device preferably controls an increase of the heat as soon as the temperature signal and/or the temperature data represents a surface temperature which is lower than a defined threshold temperature, whereby the threshold temperature is a temperature which is lower by a defined value than the set temperature or the lower limit of the set temperature range. The defined value is preferably less than 10°C or less than 5°C or less than 3°C or less than 2°C or less than 1.5°C or less than 1°C.

It is possible to use the term "elements" in exchange to "substances" or "element" in exchange to "substance".

Further advantages, objectives and features of the present invention are explained with reference to the following description of accompanying drawings, in which the device(s) according to the invention are shown by way of example. Components or elements of the device according to the invention, which at least substantially correspond in the figures with respect to their function, can be marked with the same reference signs, whereby these components or elements do not have to be numbered or explained in all figures.

Individual or all representations of the figures described in the following are preferably to be regarded as construction drawings, i.e., the dimensions, proportions, functional relationships and/or arrangements resulting from the figure or figures preferably correspond exactly or preferably substantially to those of the device according to the invention or the product according to the invention or the method according to the invention.

Therein shows:
- Fig. 1a: schematically an example of CVD reactor, wherein heat generation results from conducting electric energy through a SiC growth substrate to heat the SiC growth substrate by resistant heating,
- Fig. 1b: schematically shows an example of the present invention, wherein a wall is heated on one side by means of a flame and wherein the other side of said wall is arranged inside a reaction space or forms a reaction space,
- Fig. 2a: schematically a cross-sectional view of a CVD reactor according to the present invention,
- Fig. 2b: schematically a cross-sectional view of another CVD reactor according to the present invention,
- Fig. 3: schematically an example of a further CVD reactor design according to the present invention,
- Fig. 4a: schematically an example of a gas guide for guiding a gas to be burned to one or multiple combustion outlet/s,
- Fig. 4b: schematically a cross-sectional view of a further CVD reactor according to the present invention,
- Fig. 4c: the gas guide of fig. 4a, wherein flames burning the conducted gas are illustrated schematically,
- Fig. 4d: schematically another cross-sectional of the CVD reactor of fig. 4b,
- Fig. 5: schematically shows another type of heating unit, wherein the burned gases are guided through a pipe system to heat the SiC growth substrate/s,
- Fig. 6a: schematically shows a further type of heating unit, wherein a fluid is heated which is guided in a pipe, wherein another substance, in particular gas, is burned to provide heat for heating the fluid inside said pipe,
- Fig. 6b: schematically shows an example of a heat transfer arrangement for transferring heat from the burned gas to the fluid, in particular gas and/or liquid, inside the pipe,
- Fig. 6c: schematically that the SiC growth substrate can have straight sections connected via one or more curved sections and can act as fluid, in particular gas and/or liquid, guide means,
- Fig. 7a: schematically a hollow housing that can act as SiC growth substrate or that can hold a SiC growth substrate,
- Fig. 7b: schematically the hollow housing of Fig. 7a on an example of a holding and/or carrying structure,
- Fig. 7c: schematically a SiC growth substrate formed as foil, wherein the foil is positioned on the hollow housing,
- Fig. 7d: schematically a side view of the hollow housing of Fig. 7a and a heating unit, wherein the heating unit can be covered by the hollow housing,
- Fig. 7e: schematically a cross-section view showing SiC grown on a foil arranged on the hollow housing,
- Fig. 8a: schematically a further hollow housing,
- Fig. 8b: schematically an arrangement having a carrying member, in particular a rodlike element or a rod, positioned on top of the hollow housing for holding at least one foil,
- Fig. 8c: schematically a cross-section view showing SiC grown on a foil arranged on the hollow housing,
- Fig. 9a: schematically a further example of a CVD reactor according to the present invention,
- Fig. 9b: schematically the CVD according to Fig. 9a, wherein the CVD reactor comprises a cooling unit for cooling the housing,
- Fig. 9c: schematically a cross-sectional view of a further CVD reactor, wherein growth faces of multiple SiC growth substrates are parallel to each other or at least significantly overlay each other,
- Fig. 9d: schematically a side view of a SiC growth substrate respectively of a hollow housing, wherein one growth face faces into a first direction and a second growth face faces into a second direction,
- Fig. 9e: schematically a side view of a SiC growth substrate respectively of a hollow housing, wherein one growth face faces into a first direction and a second growth face faces into a second direction, wherein the second direction is aligned in an angle with respect to direction OD1,
- Fig. 10: schematically a further CVD reactor design, wherein the individual Sic growth substrates are aligned with respect to each other,
- Fig. 11a: schematically a further CVD reactor design, wherein the individual SiC growth substrates overlap the neighboring SiC growth substrates,
- Fig. 11b: schematically shows a further example of the design of a SiC growth substrate, in particular of a hollow housing,
- Fig. 11c: schematically enhanced overlap in circular reactor design,
- Fig. 12: schematically an example of a section of the CVD reactor according to fig. 10 or 11 in a perspective view.

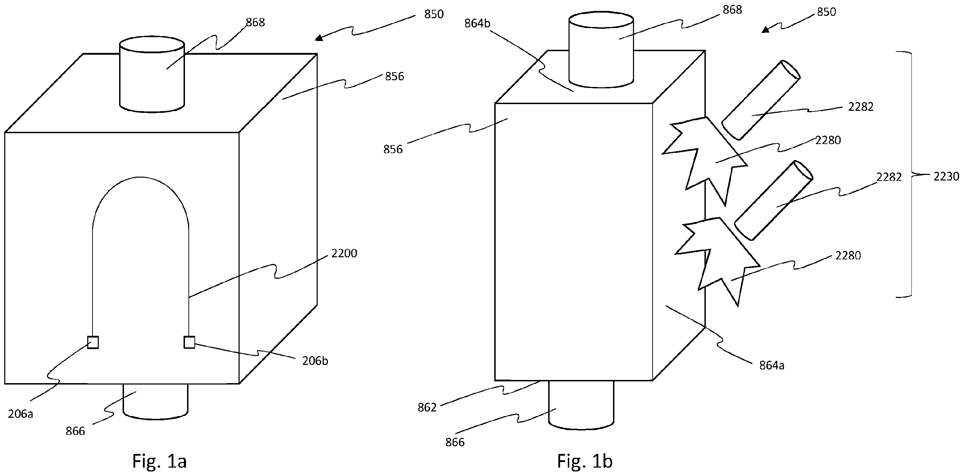

Fig. 1a schematically shows an example of a CVD reactor 850. Said CVD reactor 850 comprises a process chamber 856 a gas inlet unit 866, in particular a pipe, for feeding gas into the process chamber 856 and a gas outlet unit 868, in particular a pipe, for removing remaining gas from the process chamber 856. Inside the process chamber 856 a SiC growth substrate 2200 is provided, wherein said SiC growth substrate 2200 is coupled with a first end with a first electrode 206a and with a second end with a second electrode 206b. Electric energy is conducted form one electrode 206a to the other electrode 206b and therefore through the SiC growth substrate 2200 for heating the SiC growth substrate 2200. A CVD reactor similar to the CVD reactor 850 is described in detail by PCT/EP2021/085513, which is entirely incorporated by reference into the subject-matter of the present disclosure.

Fig. 1b shows an example of a SiC production reactor 850 according to the present invention. Said SiC production reactor 850 preferably comprises a process chamber 856, wherein the process chamber 856 is at least surrounded by a bottom wall section, in particular a base plate 862 or base plate wall section, a side wall section 864a and a top wall section 864b,
a gas inlet unit 866 for feeding one feed-medium or multiple feed-mediums into a reaction space of the process chamber 856 for generating a source medium. The gas inlet unit 866 is preferably coupled with at least one feed-medium source 851, wherein a Si and C feed-medium source 851 is configured to provide at least Si and C, in particular SiCl3(CH3), and wherein a carrier gas feed-medium source 853 provides a carrier gas, in particular H2, or wherein the gas inlet unit 866 is coupled with at least two feed-medium sources 851, 852, wherein a Si feed medium source 851 is configured to provide at least Si and wherein a C feed medium source 852 provides at least C, in particular natural gas, Methane, Ethane, Propane, Butane and/or Acetylene, and wherein a carrier gas medium source 853 is configured to provide a carrier gas, in particular H2. The reactor 850 preferably also comprises at least one SiC growth substrate surface 2204 is formed inside the process chamber 856 by a wall surface section 2270, and a heating unit 2230 for non-electrically generation of heat is provided, wherein the heating unit 2230 is configured for heating at least the SiC growth substrate surface 2204 to a temperature above 1300°C.

The heating unit 2230 comprises according to the present example at one or multiple combustion guide element/s 2282 for causing a flame 2280 for heating the wall member 864a. It is also possible that one or multiple flames 2280 can be caused to directly heat one or multiple further wall sections, in particular an opposing wall section and/or one or multiple neighboring wall section and/or a top wall section 864b and/or a bottom wall section 862.

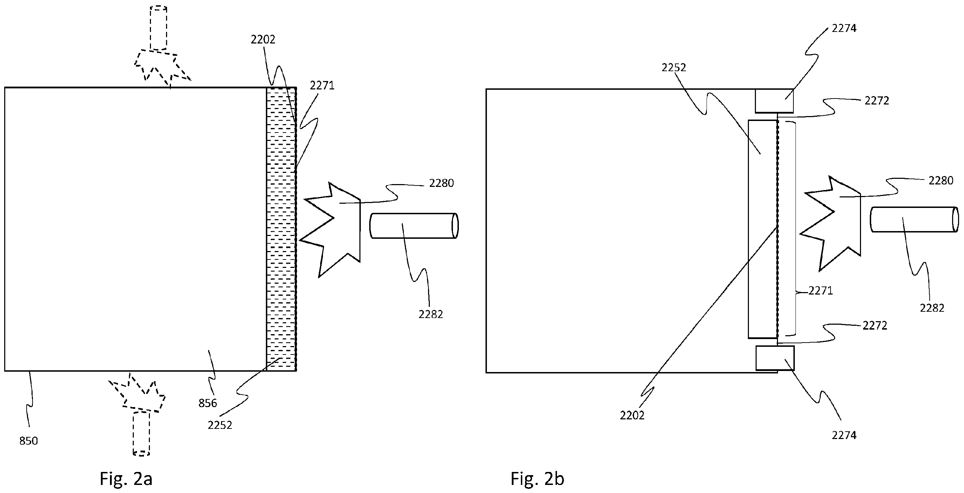

Fig. 2a shows that at least one flame 2280 heats up wall member 2271 form one side and SiC deposits on the other side - which can be understood as SiC growth face of said wall member 2271. The dotted lines schematically indicate that one or multiple further wall member/s can be heated with flames 2280. Burning of gas is a reliable and cheap method for heating the wall member 2271.

According to Fig. 2b cooling elements 2274 can be provided for cooling down the SiC growth face 2202 to a temperature below the lowest deposition temperature. Thus, growth of SiC can be limited to a defined surface section 2271 of the first SiC growth face 2202. Deposition of SiC is thus prevented in colder sections 2272.

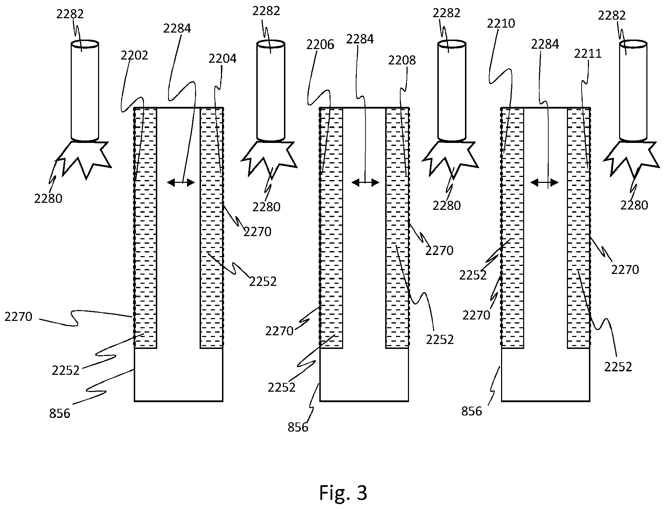

Fig. 3 schematically shows an example of a reactor design, according to which heat radiation 2284 from one growth face radiates to an overlaying growth face. Fig. 3 additionally shows that a reactor 850 according to the present invention can comprise more than four SiC growth substrates 2200a-d and preferably six or more than six SiC growth substrates2200a-f.

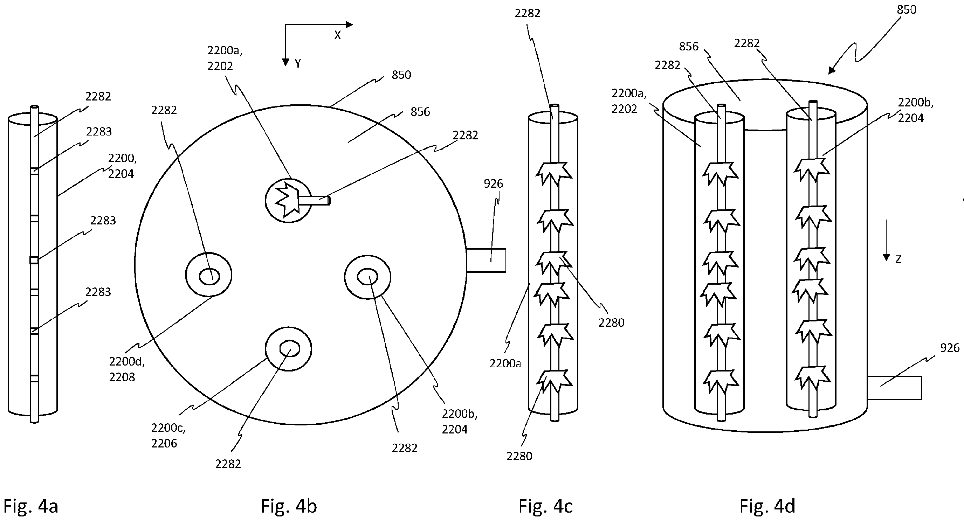

Fig. 4a shows an example of a SiC growth substrate 2200 having at least one growth face 2204, wherein a heat guide or gas guide 2282, in particular pipe, for heating the at least one growth face 2204 to a temperature above 1300°C is provided. The gas guide 2282 preferably comprises at least one or multiple outlets 2283 for letting out the guided gas for burning said gas and thereby preferably causing at least one flame 2280.

Fig. 4b shows that multiple SiC growth substrates 2200a-d can be arranged inside a CVD reactor 850 according to the present invention. Each SiC growth substrate 2200a-d preferably forms at least one growth face section 2202, 2204, 2206 and 2208. Furthermore, preferably each SiC growth substrate 2200a-d surrounds a fluid guide passage for heating the respective SiC growth substrate 2200a-d. According to the described kind of SiC growth substrates 2200a-d a fast SiC deposition takes place since the available surface size is already large at the beginning of a production run (compared to resistive heating rods).

Fig. 4c shows one SiC growth substrate 2200a heated from the inside, in particular by burning a fluid provided via fluid guide 2282.

Fig. 4d schematically shows how multiple of said SiC growth substrates 2200a-b are heated during a production run. Reference number 926 refers to a control unit for controlling one or multiple parameters of the production process, e.g., heating and/or gas flow into the process chamber and/or cooling, etc.

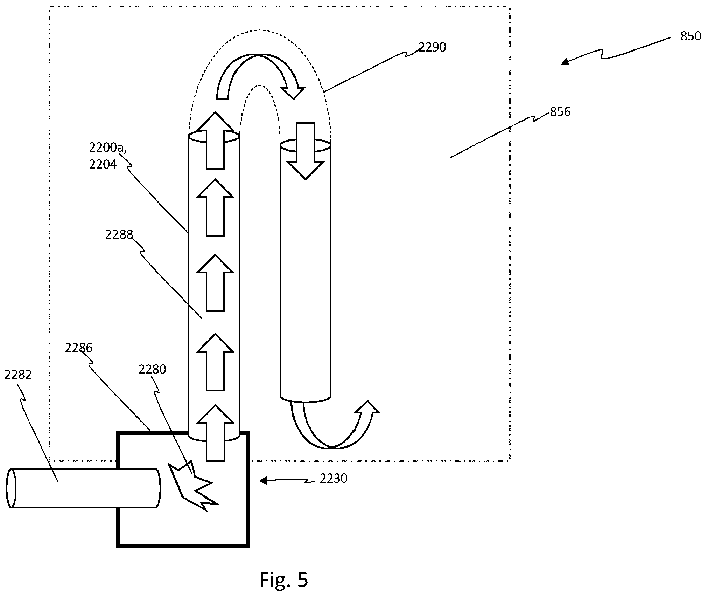

Fig. 5 shows a further preferred example of a SiC production reactor 850 according to the present invention. Said production reactor preferably comprises at least a process chamber 856,
a gas inlet unit 866 for feeding one feed-medium or multiple feed-mediums into a reaction space of the process chamber 856 for generating a source medium. The reactor 850 preferably also comprises at least one SiC growth substrate surface 2204 which is formed inside the process chamber 856 by a wall surface section 2270, wherein the wall surface section 2270 is preferably a wall section of a SiC growth substrate 2200a. Additionally the reactor preferably comprises a heating unit 2230 for non-electrically generation of heat, wherein the heating unit 2230 is configured for heating at least the SiC growth substrate surface 2204 to a temperature above 1300°C, wherein the heating unit 2230 preferably forms a fluid guide means 2288 for guiding fluid heated to a temperature above 1300°C for heating the wall member 2271, in particular the SiC growth substrate, for heating the wall surface section 2270, in particular of the SiC growth substrate respectively the growth face of the deposited SiC. The fluid is preferably generated respectively heated by burning an energy liquid, in particular natural gas or H2 or biogas or methane etc.

The process chamber 856 is preferably at least surrounded by a bottom wall section, in particular a base plate 862 or base plate wall section, a side wall section 864a and a top wall section 864b. The gas inlet unit 866 is preferably coupled with at least one feed-medium source 851, wherein a Si and C feed-medium source 851 is preferably configured to provide at least Si and C, in particular SiCl3(CH3), and wherein a carrier gas feed-medium source 853 provides a carrier gas, in particular H2. Alternatively, it is possible that the gas inlet unit 866 is coupled with at least two feed-medium sources 851, 852, wherein a Si feed medium source 851 is preferably configured to provide at least Si and wherein a C feed medium source 852 preferably provides at least C, in particular natural gas, Methane, Ethane, Propane, Butane and/or Acetylene, and wherein a carrier gas medium source 853 is preferably configured to provide a carrier gas, in particular H2,

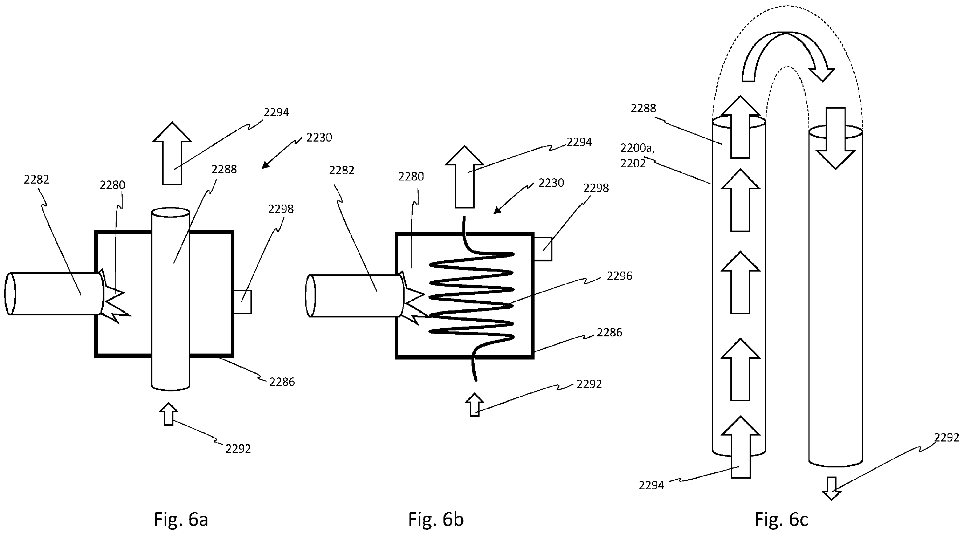

Fig. 6a and b schematically disclose alternative heating units 2230. According to the heating unit 2230 of fig. 6a and 6b the fluid, in particular natural gas, methane, biogas or H2, is burned to heat a further fluid which is arranged inside a fluid guide 2288, in particular a pipe. Reference number 2298 indicates an outlet for removing the burned fluid from the combustion compartment 2286.

The small arrow 2292 indicates a low fluid temperature inside the fluid guide 2288 and the larger arrows 2294 indicate an increased fluid temperature. Fig. 6b shows a surface increased (compared to fig. 6a) heat exchanger 2296.

Fig. 6c schematically shows that the heated fluid, in particular a gas, travels through the SiC growth substrate 2200a for increasing the temperature of the growth face section above 1300°C.

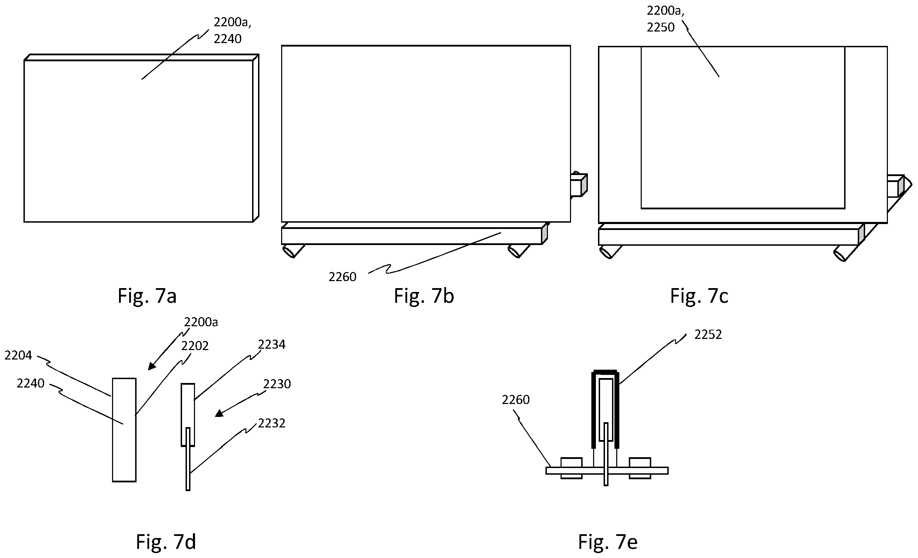

Fig. 7a schematically shows a hollow housing 2240, wherein the hollow housing 2240 is preferably made of graphite or CFC material, in particular thin sheets of CFC material. The average wall thickness of the hollow housing 2240 is preferably smaller than 5cm and particular preferably smaller than 3cm and highly preferably smaller than 1cm and most preferably smaller than 0,5cm.

Fig. 7b schematically shows the hollow housing 2240 of fig. 7a positioned on a carrying and/or holding unit 2260.

According to fig. 7c a SiC growth substrate 2200a, in particular a thin and/or flexible SiC growth substrate 2200a, is arranged on at least sections of the outer surface of the hollow housing 2240. The SiC growth substrate 2200a is preferably configured as thin sheets of CFC material, wherein "thin" means a thickness of less than 3cm and preferably of less than 1cm and highly preferably of less than 0,5cm and most preferably of less than 0,25cm (per sheet).

Fig. 7d shows a side view of the hollow housing 2240 and schematically an example of a heating unit 2230. The heating unit 2230 can be a resistive heating unit 2230, wherein electric energy is conducted via electrodes 2232 through a heat emitting element, in particular at least one electric resistor, or a heating unit analog to any of figures 4a-d, 5 or 6a-c.

Fig. 7e schematically shows a situation during or after a production run, wherein a crust 2252 of SiC is deposited onto the SiC growth substrate 2200a, in particular the hollow housing 2240 or the foil 2250.

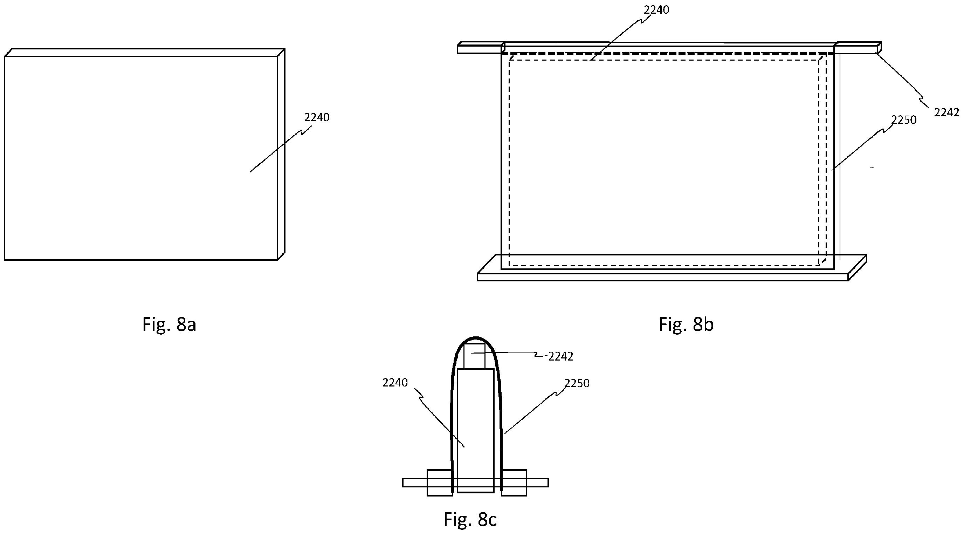

Fig. 8a schematically shows a further example of a hollow housing 2240.

Fig. 8b schematically shows a SiC growth substrate, in particular foil 2250, holding member 2242 arrange on or above the hollow housing 2240. A SiC growth substrate 2200a, in particular a foil and/or one or multiple sheets of CFC material, is arranged on the SiC growth substrate holding member 2242 and overlaps preferably more than 50% of the outer surface of the hollow housing 2240 and preferably more than 75% of the outer surface of the hollow housing 2240 and most preferably more than 85% of the outer surface of the hollow housing 2240. The SiC growth substrate, in particular foil, holding member 2242 can be separated from the hollow housing 2240 without damaging or destroying the hollow housing 2240.

Thus, after a production run the grown SiC can be easily removed by means of the SiC growth substrate, in particular foil, holding member 2242.

Fig. 8c schematically shows a side view of the arrangement of fig. 8b.

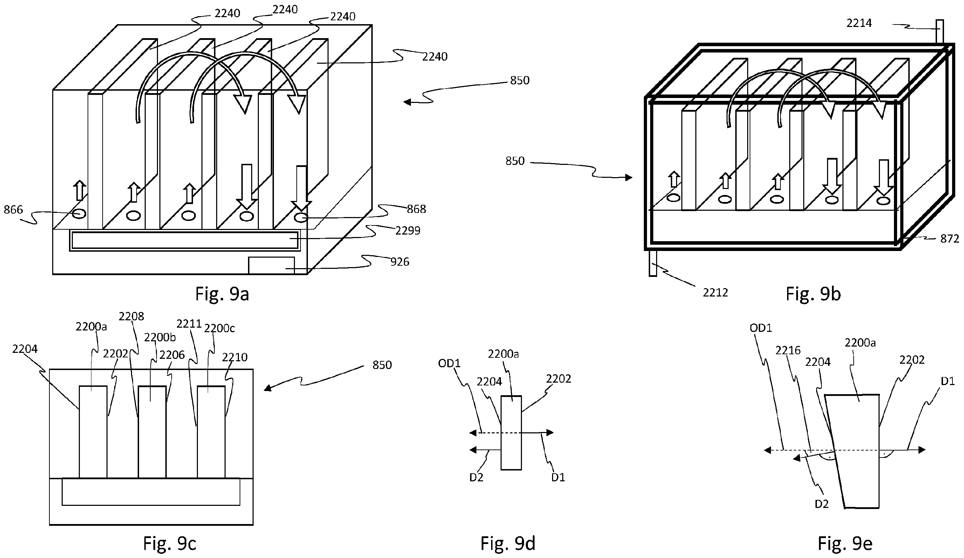

Fig. 9a schematically shows an example of a further SiC production reactor 850, in particular for the production of 3C-SiC material, according to the present invention. The reactor 850 preferably comprises one or multiple, in particular more than 2 or more than 4 or more than 10 or up to 20 or up to 50 or up to 100, hollow housings 2240 (e.g., as described with respect to fig. 7a-e and/or fig. 8a-c), wherein at least some of the hollow housings 2240 and preferably 50% or more than 50% of the hollow housings 2240 cover heating units 2230.

A source gas or source gas mixture can be feed into the reaction space via one or multiple gas inlet units 866, wherein preferably at least one gas inlet unit 866 is preferably arranged between two hollow housings 2240. The gas, which is feed into the reaction space, is preferably further heated. It is possible to remove heat from the heated gas by means of a heat exchanger 2299, in particular positioned below the hollow housings 2240.

Fig. 9b further shows another example of a SiC production reactor 850 according to the present invention, wherein a cooling guide 872 is provided, in particular in or on a wall which forms the process chamber 856, for actively removing heat from the wall. Thus, due to the cooling the wall, which forms the process chamber 856, can be made of metal, in particular steel. Reference number 2212 indicates a cooling fluid inlet for feeding cooling fluid into the cooling fluid guide 872 and reference number 2214 indicates a cooling fluid outlet for removing the cooling fluid from the cooling fluid guide 872.

Fig. 9c schematically shows a further example of a SiC reactor 850 of the present invention. The SiC reactor 850 comprises multiple SiC growth substrates 2200a, 2200b and 2200c. The growth faces 2202 and 2208 are arranged opposite to each other. The same applies to growth faces 2206 and 2211. This embodiment is beneficial since heat radiation radiated from one of said growth faces 2202, 2208, 2206 and 2211 heats the overlapping growth face.

The fourth growth face section 2208 preferably overlays in a first direction D1 at least 50% of the first growth face section 2202, wherein the size of the fourth growth face section 2208 is at least 80%, in particular more than 90% or more 95%, of the size of the first growth face section 2208.

The sixth growth face section 2211 preferably overlays in a fifth direction D5 at least 50% of the third growth face section 2206, wherein the size of the sixth growth face section 2211 is at least 80%, in particular more than 90% or more 95%, of the size of the third growth face section 2206.

Fig. 9d schematically shows an example of a SiC growth substrate 2200a having a first growth face section 2202 and a second growth face section 2204. The direction D1 indicates a normal of the first growth face section 2202. The direction D2 indicates a normal of the second growth face section 2204. OD1 indicates a direction opposite to D1. According to fig. 9d D2 and OD1 are parallel to each other. Thus, the second direction D2 is aligned less than 20°, in particular less than 10° or less than 5°, to the opposite direction OD1 of the first direction D1.

Fig. 9e schematically shows a further example of a SiC growth substrate 2200a having a first growth face section 2202 and a second growth face section 2204. The direction D1 indicates a normal of the first growth face section 2202. The direction D2 indicates a normal of the second growth face section 2204. OD1 indicates a direction opposite to D1. According to fig. 9e D2 and OD1 are inclined to each other. According to the present invention the angle between D2 and OD1 is preferably less than 20°, in particular less than 10° or less than 5°.

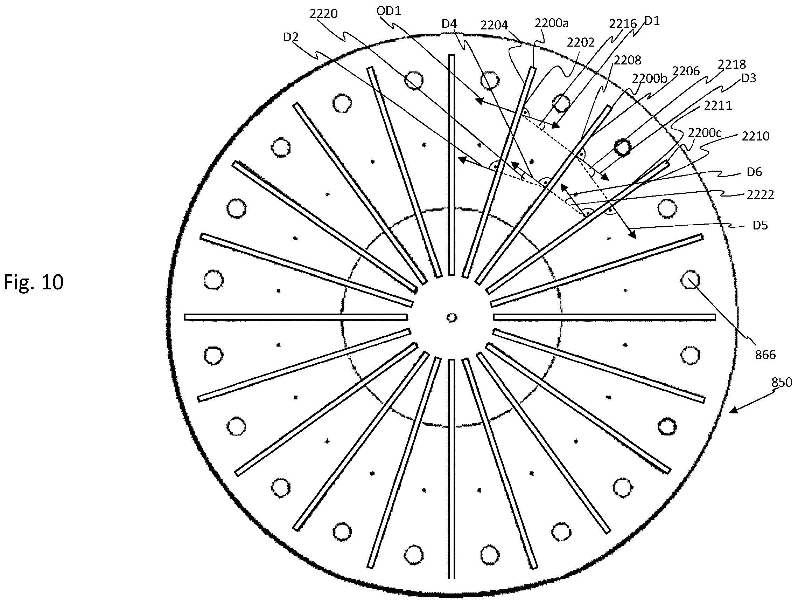

Fig. 10 schematically shows an example of a further SiC reactor 850 of the present invention. The SiC reactor 850 comprises a plurality of SiC growth substrates 2200a-x. Said SiC growth substrates 2200a-x are preferably formed in a plate-shaped manner and/or form hollow housings 2240. The SiC growth substrates 2200a-x can be electrically heated, in particular by conducting current through the SiC growth substrates 2200a-x. In case at least some or all of the SiC growth substrates 2200a-x are hollow housings 2240 the hollow housings 2240 preferably cover heating units 2230 for heating the SiC growth substrates 2200a-x.

The first SiC growth substrate 2200a of said multiple SiC growth substrates 2200a-x comprises at least a first growth face section 2202 facing into a first directing D1 and a second growth face section 2204 facing into a second direction D2, wherein the second direction D2 is aligned less than 20°, in particular less than 10° or less than 5°, to the opposite direction OD1 of the first direction D1. The second SiC growth substrate 2200b of said multiple SiC growth substrates 2200a-x comprises at least a third growth face section 2206 facing into a third direction D3, wherein the third direction D3 is aligned less than 20°, in particular less than 10° or less than 5°, to the first direction D1 and a fourth growth face section 2208 facing into a fourth direction D4. The third SiC growth substrate 2200c of said multiple SiC growth substrates 2200a-x comprises at least a fifth growth face section 2210 facing into the fifth direction D5, wherein the fifth direction D5 is aligned less than 20°, in particular less than 10° or less than 5°, to the third direction D3 and a sixth growth face section 2211 facing into a sixth direction D6. The same applies for all remaining SiC growth substrates 2200d-x, which are not described in the following.

The features described with respect to fig. 7a-9e can be applied in analogous manner and vice versa.

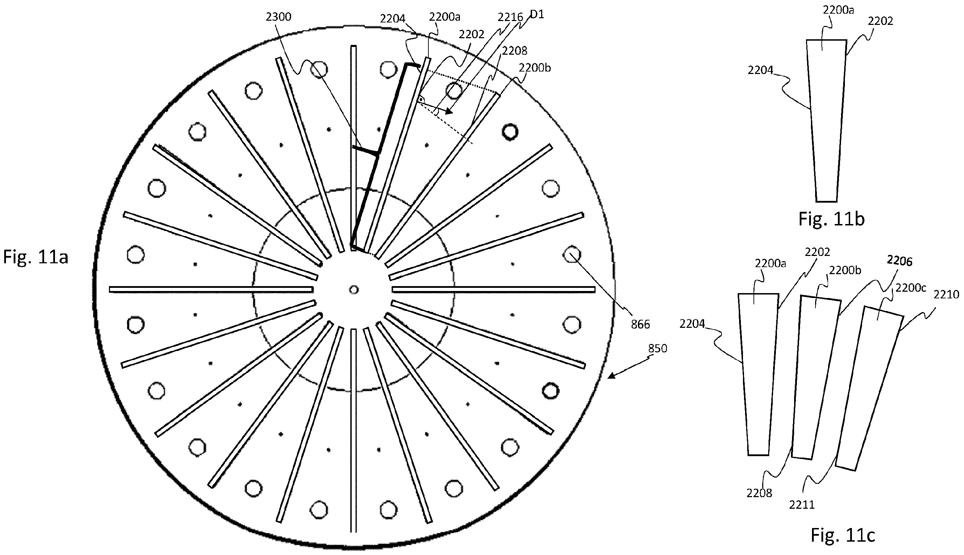

Fig. 11a shows the reactor shown in fig. 10 and indicates that the the fourth growth face section 2208 overlays in the first direction D1 at least 50% of the first growth face section 2202, wherein the size of the fourth growth face section 2208 is at least 80%, in particular more than 90% or more 95%, of the size of the first growth face section 2202 and wherein the sixth growth face section 2211 overlays in the fifth direction D5 at least 50% of the third growth face section 2206, wherein the size of the sixth growth face section 2211 is at least 80%, in particular more than 90% or more 95%, of the size of the third growth face section 2206, etc. This embodiment is beneficial since radiated heat heats an opposing growth face and therefore significantly reduces radiation losses.

Fig. 11b schematically shows a SiC growth substrate 2200a, which can be provided as hollow housing, respectively a hollow housing 2240 for folding a SiC growth substrate 2200a, in particular a foil 2250. In particular in case of a circular reactor a SiC growth substrate 2200a respectively a hollow housing 2230 having a triangular or cone shape can be beneficial to increase the overlap between overlapping growth face sections.

Fig. 11c schematically shows an enhanced overlap of overlapping growth face sections 2202 and 2208 and/or 2206 and 2211.

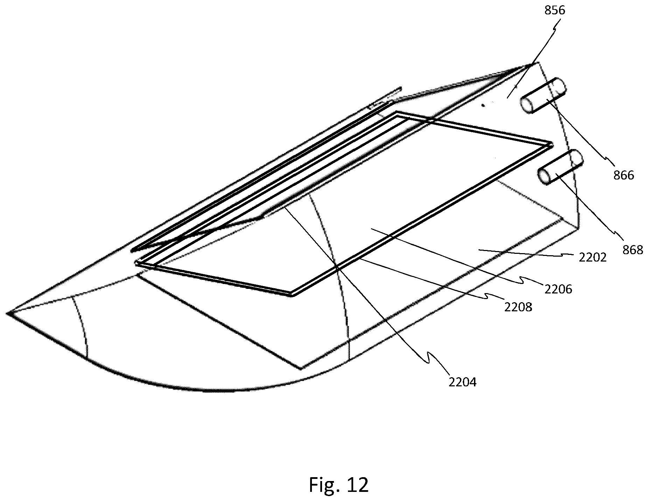

Fig. 12 schematically shows a section of the reactor of fig. 10 and 11 in a perspective view.

Thus, the present invention refers to a SiC production reactor 850, at least comprising a process chamber 856, wherein the process chamber (856) is at least surrounded by a bottom wall section 862, in particular a base plate 862 wall section, a side wall section 864a and a top wall section 864b,
a gas inlet unit 866 for feeding one feed-medium or multiple feed-mediums into a reaction space of the process chamber 856 for generating a source medium, wherein the gas inlet unit 866 is coupled with at least one feed-medium source 851, wherein a Si and C feed-medium source 851 is configured to provide at least Si and C, in particular SiCl3(CH3), and wherein a carrier gas feed-medium source 853 is configured to provide a carrier gas, in particular H2, or wherein the gas inlet unit 866 is coupled with at least two feed-medium sources 851, 852, wherein a Si feed medium source 851 is configured to provide at least Si and wherein a C feed medium source 852 is configured to provide at least C, in particular natural gas, Methane, Ethane, Propane, Butane and/or Acetylene, and wherein a carrier gas medium source 853 provides a carrier gas, in particular H2, multiple SiC growth substrates 2200a-x, in particular more than 3 or 4 or 6 or 8 or 16 or 32 or 64 or up to 128 or up to 256, are arranged inside the process chamber 856 for depositing SiC, wherein a first SiC growth substrate 2200a of said multiple SiC growth substrates 2200a-x comprises at least a first growth face section 2202 facing into a first directing D1 and a second growth face section 2204 facing into a second direction D2, wherein the second direction D2 is aligned less than 20°, in particular less than 10° or less than 5°, to the opposite direction OD1 of the first direction D1, wherein a second SiC growth substrate 2200b of said multiple SiC growth substrates 2200a-x comprises at least a third growth face section 2206 facing into a third direction D3, wherein the third direction D3 is aligned less than 20°, in particular less than 10° or less than 5°, to the first direction D1 and a fourth growth face section 2208 facing into a fourth direction D4, wherein a third SiC growth substrate 2200c of said multiple SiC growth substrates 2200a-x comprises at least a fifth growth face section 2210 facing into the fifth direction D5, wherein the fifth direction D5 is aligned less than 20°, in particular less than 10° or less than 5°, to the third direction D3 and a sixth growth face section 2211 facing into a sixth direction D6, wherein the fourth growth face section 2208 overlays in the first direction D1 at least 50% of the first growth face section 2202, wherein the size of the fourth growth face section 2208 is at least 80%, in particular more than 90% or more 95%, of the size of the first growth face section 2208, wherein the sixth growth face section 2211 overlays in the fifth direction D5 at least 50% of the third growth face section 2206, wherein the size of the sixth growth face section 2211 is at least 80%, in particular more than 90% or more 95%, of the size of the third growth face section 2206.

Thus, the present invention refers to a SiC production reactor 850, wherein the SiC production reactor 850 at least comprises: A process chamber 856, wherein the process chamber 856 is at least surrounded by a bottom wall section, in particular a base plate 862 or base plate wall section, a side wall section 864a and a top wall section 864b,
a gas inlet unit 866 for feeding one feed-medium or multiple feed-mediums into a reaction space of the process chamber 856 for generating a source medium, wherein the gas inlet unit 866 is coupled with at least one feed-medium source 851, wherein a Si and C feed-medium source 851 is configured to provide at least Si and C, in particular SiCl3(CH3), and wherein a carrier gas feed-medium source 853 provides a carrier gas, in particular H2, or wherein the gas inlet unit 866 is coupled with at least two feed-medium sources 851, 852, wherein a Si feed medium source 851 is configured to provide at least Si and wherein a C feed medium source 852 provides at least C, in particular natural gas, Methane, Ethane, Propane, Butane and/or Acetylene, and wherein a carrier gas medium source 853 is configured to provide a carrier gas, in particular H2, at least one SiC growth substrate surface 2204 is formed inside the process chamber 856 by a wall surface section 2270, a heating unit 2230 for non-electrically generation of heat is provided, wherein the heating unit 2230 is configured for heating at least the SiC growth substrate surface 2204 to a temperature above 1300°C.

| | | | |
|---|---|---|---|
| **List of reference numbers** | | 2206 | third growth face section |
| | | 2208 | fourth growth face section |
| 206a | first electrode | 2210 | fifth growth face section |
| 206b | second electrode | 2211 | sixth growth face section |
| 850 | SiC production reactor | 2212 | cooling fluid inlet |
| 851 | Si and C feed-medium source | 2214 | cooling fluid outlet |
| | or Si feed medium source | 2216 | angle between D1 and D3 |
| 852 | C feed-medium source | 2218 | angle between D3 and D5 |
| 853 | carrier gas feed-medium source | 2220 | angle between D2 and D4 |
| | | 2222 | angle between D4 and D6 |
| 856 | process chamber / reaction space | | |
| | | 2230 | heating unit |
| 862 | bottom wall section | 2232 | electrodes |
| 864a | side wall section | 2234 | heat emitting element |
| 864b | top wall section | 2240 | hollow housing |
| 866 | gas inlet unit | 2242 | foil holding member, in particular foil holding rod |
| 868 | gas outlet unit | 2250 | foil - thin and/or flexible substrate |
| 872 | cooling fluid guide | | |
| 926 | control device or control unit | 2252 | SiC grown on SiC growth substrate |
| 2200a-x | SiC growth substrates | | |
| 2200a | first SiC growth substrate | 2260 | carrying and/or holding unit |
| 2200b | second SiC growth substrate | 2270 | wall surface section of the wall member |
| 2200c | third SiC growth substrate | | |
| 2202 | first growth face section | 2270a | side wall section |
| 2204 | second growth face section | 2270b | top wall section |
| | | 2271 | wall member |
| 2272 | cooler section of the wall member | 2294 | hot fluid |
| | | 2296 | heat exchanger |
| 2274 | cooling element | 2298 | exhaust pipe |
| 2280 | flame | 2299 | heat exchanger |
| 2282 | energy source / combustion fluid | 2300 | overlayed surface section |
| | | D1 | first direction |
| 2283 | combustion gas outlet | OD1 | opposite to first direction |
| 2284 | heat radiation | D2 | second direction |
| 2286 | combustion compartment | D3 | third direction |
| 2288 | hot gas channel / combustion gas guide / fluid guide means | D4 | fourth direction |
| 2290 | deflector member | D5 | fifth direction |
| 2292 | cold fluid | D6 | sixth direction |

## Claims

1. SiC production reactor (850),
at least comprising
a process chamber (856), wherein the process chamber (856) is at least surrounded by a bottom wall section (862), in particular a base plate (862) wall section, a side wall section (864a) and a top wall section (864b),
a gas inlet unit (866) for feeding one feed-medium or multiple feed-mediums into a reaction space of the process chamber (856) for generating a source medium,
wherein the gas inlet unit (866) is coupled with at least one feed-medium source (851),
wherein a Si and C feed-medium source (851) is configured to provide at least Si and C, in particular SiCl3(CH3), and wherein a carrier gas feed-medium source (853) is configured to provide a carrier gas, in particular H2,
or
wherein the gas inlet unit (866) is coupled with at least two feed-medium sources (851, 852),
wherein a Si feed medium source (851) is configured to provide at least Si and wherein a C feed medium source (852) is configured to provide at least C, in particular natural gas, Methane, Ethane, Propane, Butane and/or Acetylene, and wherein a carrier gas medium source (853) provides a carrier gas, in particular H2,
multiple SiC growth substrates (2200a-x), in particular more than 3 or 4 or 6 or 8 or 16 or 32 or 64 or up to 128 or up to 256, are arranged inside the process chamber (856) for depositing SiC,
wherein a first SiC growth substrate (2200a) of said multiple SiC growth substrates (2200a-x) comprises at least a first growth face section (2202) facing into a first directing (D1) and a second growth face section (2204) facing into a second direction (D2), wherein the second direction (D2) is aligned less than 20°, in particular less than 10° or less than 5°, to the opposite direction (OD1) of the first direction (D1),
wherein a second SiC growth substrate (2200b) of said multiple SiC growth substrates (2200a-x) comprises at least a third growth face section (2206) facing into a third direction (D3), wherein the third direction (D3) is aligned less than 20°, in particular less than 10° or less than 5°, to the first direction (D1) and a fourth growth face section (2208) facing into a fourth direction (D4),
wherein a third SiC growth substrate (2200c) of said multiple SiC growth substrates (2200a-x) comprises at least a fifth growth face section (2210) facing into the fifth direction (D5), wherein the fifth direction (D5) is aligned less than 20°, in particular less than 10° or less than 5°, to the third direction (D3) and a sixth growth face section (2211) facing into a sixth direction (D6),
wherein the fourth growth face section (2208) overlays in the first direction (D1) at least 50% of the first growth face section (2202), wherein the size of the fourth growth face section (2208) is at least 80%, in particular more than 90% or more 95%, of the size of the first growth face section (2208),
wherein the sixth growth face section (2211) overlays in the fifth direction (D5) at least 50% of the third growth face section (2206), wherein the size of the sixth growth face section (2211) is at least 80%, in particular more than 90% or more 95%, of the size of the third growth face section (2206).

2. SiC production reactor (850) according to claim 1,
**characterized in that**,
at least the first SiC growth substrate (2200a) covers from at least two sides a first heating unit (2230), wherein the first heating unit (2230) and the first SiC growth substrate (2200a) are configured to be non-destructively separatable from each other.

3. SiC production reactor (850) according to claim 2,
**characterized in that**,
the first SiC growth substrate (2200a) is formed by a hollow housing (2240), wherein the heating unit (2230) is positioned inside the hollow housing (2240).

4. SiC production reactor (850) according to claim 1,
**characterized in that**,
the first SiC growth substrate (2200a) is formed by a foil (2250) or holds a SiC growth foil (2250).

5. SiC production reactor (850) according to claim 4,
**characterized in that**,
the foil (2250) is arranged around at least two surface sections (2202, 2204) of a hollow housing (2240), wherein the heating unit (2230) is positioned inside the hollow housing (2240).

6. SiC production method, in particular for the production of 3C-SiC,
at least comprising the steps:
providing a SiC production reactor (850), wherein the SiC production reactor (850) comprises
- a process chamber (856), wherein the process chamber (856) is at least surrounded by a bottom wall section, in particular a base plate wall section (862), a side wall section (864a) and a top wall section (864b),
- a gas inlet unit (866) for feeding one feed-medium or multiple feed-mediums into a reaction space of the process chamber (856) for generating a source medium, wherein the gas inlet unit (866) is coupled with at least one feed-medium source (851),
wherein a Si and C feed-medium source (851) is configured to provide at least Si and C, in particular SiCl3(CH3), and wherein a carrier gas feed-medium source (853) provides a carrier gas, in particular H2,
or
wherein the gas inlet unit (866) is coupled with at least two feed-medium sources (851, 852),
wherein a Si feed medium source (851) is configured to provide at least Si and wherein a C feed medium source (852) provides at least C, in particular natural gas, Methane, Ethane, Propane, Butane and/or Acetylene, and wherein a carrier gas medium source (853) is configured to provide a carrier gas, in particular H2,
- multiple SiC growth substrates (2200a-x), in particular more than 3 or 4 or 6 or 8 or 16 or 32 or 64 or up to 128 or up to 256, are arranged inside the process chamber (856) for depositing SiC,
wherein a first SiC growth substrate (2200a) of said multiple SiC growth substrates (2200a-x) comprises at least a first growth face section (2202) facing into a first directing (D1) and a second growth face section (2204) facing into a second direction (D2), wherein the second direction (D2) is aligned less than 20°, in particular less than 10° or less than 5°, to the opposite direction of the first direction (D1),
wherein a second SiC growth substrate (2200b) of said multiple SiC growth substrates (2200a-x) comprises at least a third growth face (2206) section facing into the third direction (D3), wherein the third direction (D3) is aligned less than 20°, in particular less than 10° or less than 5°, to the first direction (D1) and wherein the second SiC growth substrate (2200b) comprises a fourth growth face section (2208) facing into a fourth direction (D4),
wherein a third SiC growth substrate (2200c) of said multiple SiC growth substrates (2200a-x) comprises at least a fifth growth face section (2210) facing into the fifth direction (D5), wherein the fifth direction (D5) is aligned less than 20°, in particular less than 10° or less than 5°, to the third direction and wherein the third SiC growth substrate (2200c) comprises a sixth growth face section (2211) facing into a sixth direction (D6),
wherein the fourth growth face section (2208) overlays in the first direction (D1) at least 50% of the first growth face section (2202), wherein the size of the fourth growth face section (2208) is at least 80%, in particular more than 90% or more 95%, of the size of the first growth face section (2202),
wherein the sixth growth face section (2211) overlays in the fifth direction (D5) at least 50% of the third growth face section (2206), wherein the size of the sixth growth face section (2211) is at least 80%, in particular more than 90% or more 95%, of the size of the third growth face section (2206),
and
heating the multiple SiC growth substrates (2200a-x),
feeding the one feed-medium from the one feed-medium source (851) or the multiple feed-mediums from the multiple feed-medium sources (851, 852) into the reaction space (856), depositing SiC on the first growth face section (2202) and on the second growth face section (2204) and on the third growth face section (2206) and on the fourth growth face section (2208) and on the fifth growth face section (2210) and on the sixth growth face section (2211).

7. SiC production reactor (850),
at least comprising
a process chamber (856), wherein the process chamber (856) is at least surrounded by a bottom wall section, in particular a base plate (862) or base plate wall section, a side wall section (864a) and a top wall section (864b),
a gas inlet unit (866) for feeding one feed-medium or multiple feed-mediums into a reaction space of the process chamber (856) for generating a source medium,
wherein the gas inlet unit (866) is coupled with at least one feed-medium source (851),
wherein a Si and C feed-medium source (851) is configured to provide at least Si and C, in particular SiCl3(CH3), and wherein a carrier gas feed-medium source (853) provides a carrier gas, in particular H2,
or
wherein the gas inlet unit (866) is coupled with at least two feed-medium sources (851, 852),
wherein a Si feed medium source (851) is configured to provide at least Si and wherein a C feed medium source (852) provides at least C, in particular natural gas, Methane, Ethane, Propane, Butane and/or Acetylene, and wherein a carrier gas medium source (853) is configured to provide a carrier gas, in particular H2,
at least one SiC growth substrate surface (2204) is formed inside the process chamber (856) by a wall surface section (2270),
a heating unit (2230) for non-electrically generation of heat is provided, wherein the heating unit (2230) is configured for heating at least the SiC growth substrate surface (2204) to a temperature above 1300°C.

8. SiC production reactor (850) according to claim 7,
**characterized in that**,
the heating unit (2230) is at least sectionally surrounded by a wall member forming the wall surface section.

9. SiC production reactor (850) according to claim 7,
**characterized in that**,
the wall surface section (2270) is part of the side wall section (2270a) and/or top wall section (2270b) or part of a wall member (2271) surrounded by the side wall section (2270a) and top wall section (2270b).

10. SiC production reactor (850) according to claim 7 or 8,
**characterized in that**,
the heating unit (2230) forms a fluid guide means (2288) for guiding fluid heated to a temperature above 1300°C for heating the wall member (2271) for heating the wall surface section (2270).

11. SiC production reactor (850) according to claim 7 or 8,
**characterized in that**,
the heating unit (2270) forms a fluid guide means (2288) for guiding a gas to at least one defined combustion space (2283) for burning the guided gas and thereby heating the wall member (2271) for heating the wall surface section (2270).

12. SiC production method, in particular for the production of 3C-SiC,
at least comprising the steps:
providing a SiC production reactor (850), wherein the SiC production reactor (850) comprises
- a process chamber (856), wherein the process chamber (856) is at least surrounded by a bottom wall section, in particular a base plate wall section (862), a side wall section (864a) and a top wall section (864b),
- a gas inlet unit (866) for feeding one feed-medium or multiple feed-mediums into a reaction space of the process chamber (856) for generating a source medium, wherein the gas inlet unit (866) is coupled with at least one feed-medium source (851),
wherein a Si and C feed-medium source (851) is configured to provide at least Si and C, in particular SiCl3(CH3), and wherein a carrier gas feed-medium source (853) provides a carrier gas, in particular H2,
or
wherein the gas inlet unit (866) is coupled with at least two feed-medium sources (851, 852),
wherein a Si feed medium source (851) is configured to provide at least Si and wherein a C feed medium source (852) provides at least C, in particular natural gas, Methane, Ethane, Propane, Butane and/or Acetylene, and wherein a carrier gas medium source (853) is configured to provide a carrier gas, in particular H2,
- at least one SiC growth substrate surface is formed inside the process chamber by a wall surface section,
- a heating unit for non-electrically generation of heat is provided,
and
heating the at least one SiC growth substrate surface (2204) with the heating unit (2230) to a temperature above 1300°C,
feeding the one feed-medium or the multiple feed-mediums into the reaction space (856),
depositing SiC on the at least one SiC growth substrate surface (2204).
